# EUROPEAN PATENT APPLICATION

(11) **EP 4 258 320 A1**
(43) Date of publication of application: **11.10.2023**
(21) Application number: 22167493.0
(22) Date of filing: 08.04.2022
(51) Int. Cl.: H01J 37/244, H01J 37/28

(54) **SENSOR SUBSTRATE, APPARATUS, AND METHOD**

(71) Applicant: ASML Netherlands B.V., 5500 AH Veldhoven (NL)
(72) Inventor: KROON, Ronald, 5500 AH Veldhoven (NL); VISSER, Erwin, Robert, Alexander, 5500 AH Veldhoven (NL); VAN LEEUWEN, Richard, Michel, 5500 AH Veldhoven (NL); RODRIGUES MANSANO, Andre, Luis, 5500 AH Veldhoven (NL); STEENSTRA, Herre, Tjerk, 5500 AH Veldhoven (NL); OVERLACK, Arthur Eduard, 5500 AH Veldhoven (NL)
(74) Representative: ASML Netherlands B.V.

(57) **Abstract**

The present invention provides a sensor substrate for a charged particle optical device and/or a charged particle assessment apparatus, the sensor substrate comprising: at least one distance sensor configured to generate a measurement signal representative of a distance between the distance sensor and a facing surface of a target; and at least one charged particle optical component.

## Description

### FIELD

The embodiments provided herein generally relate to a sensor substrate, an apparatus, and a method.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal particles, e.g. electrons, to be emitted from the surface, such as secondary electrons, backscattered electrons or Auger electrons. The generated signal particles may be emitted from the material structure of the sample. By scanning the primary electron beam as the probing spot over the sample surface, signal particles can be emitted across the surface of the sample. By collecting these emitted signal particles from the sample surface, a pattern inspection tool may obtain data representing characteristics of the material structure of the surface of the sample. The data may be referred to as an image and may be rendered into an image.

In general, it is important to know the specific location of certain components (such as a detector) relative to other components or members and/or the sample (or sample position). However, it can be difficult to know the exact location of a component due to mechanical tolerances between a component and a sensor used to detect the position of the component. Additionally, the amount of space available for the introduction of sensors to accurately detect the location of a component is limited.

### SUMMARY

It is an object of the present disclosure to provide ways of measuring a distance to a target, such as a sample surface or sample position.

According to an aspect of the invention, there is provided a sensor substrate for a charged particle optical device and/or a charged particle assessment apparatus, the sensor substrate comprising: at least one distance sensor configured to generate a measurement signal representative of a distance between the distance sensor and a facing surface of a target; and at least one charged particle optical component.

According to an aspect of the invention, there is provided a sensor substrate for a multi-beam charged particle optical device and/or a charged particle assessment apparatus, the sensor substrate comprising a plurality of distance sensors configured to generate a measurement signal representative of a distance between the distance sensor and a facing surface of a target.

According to an aspect of the invention, there is provided a charged particle device for projecting a multi-beam of charged particles towards a sample position, the charged particle device comprising the sensor substrate described herein.

According to an aspect of the invention, there is provided a charged particle assessment apparatus for assessing a sample, desirably configured to project a beam of charged particles towards the sample, the charged particle assessment apparatus comprising the sensor substrate described herein, desirably comprising a source configured to emit a charged particle beam, and desirably comprising the charged particle device described herein wherein the charged particle device comprises the sensor substrate.

According to an aspect of the invention, there is provided a charged particle assessment apparatus for assessing a sample, the charged particle assessment apparatus comprising a sensor substrate described herein.

According to an aspect of the invention, there is provided a method of generating a measurement signal representative of a distance between a distance sensor to a facing surface of a target using a sensor substrate comprising at least one distance sensor and at least one charged particle optical component, the method comprising: a) positioning the sensor substrate so that the distance sensor faces a facing surface of the target; and b) generating, using the distance sensor, a measurement signal representative of the distance between the distance sensor and the facing surface of a target.

According to an aspect of the invention, there is provided a method of generating a measurement signal representative of a distance between a distance sensor to a facing surface of a target using a sensor substrate comprising a plurality of distance sensors, the method comprising: a) positioning the sensor substrate so that the distance sensor faces a facing surface of the target; and b) generating, using the distance sensor, a measurement signal representative of the distance between the distance sensor and the facing surface of a target.

According to an aspect of the invention, there is provided a method of projecting a beam of charged particles onto a sample so as to detect signal particles emitted from the sample using a sensor substrate comprising at least one distance sensor and at least one signal detector, the method comprising: a) positioning the sensor substrate so that the distance sensor faces a facing surface of the sample; b) generating, using the distance sensor, a measurement signal representative of the distance between the distance sensor and the facing surface of the sample; c) controlling the position of the sensor substrate and/or the sample and/or a sample holder based on the measurement signal; d) projecting a charged particle beam along a primary beam path onto a surface of the sample; and e) detecting signal particles emitted from the sample at the at least one signal detector.

### BRIEF DESCRIPTION OF FIGURES

The above and other aspects of the present disclosure will become more apparent from the description of exemplary embodiments, taken in conjunction with the accompanying drawings.
**Figure 1** is a schematic diagram illustrating an exemplary charged particle beam assessment (e.g. inspection) apparatus.
**Figure 2** is a schematic diagram illustrating an exemplary multi-beam apparatus that is part of the exemplary charged particle beam assessment apparatus of **Figure 1****.**
**Figure 3** is a schematic diagram of an exemplary multi-beam apparatus according to an embodiment.
**Figure 4** is a bottom view of the portion of a detector assembly in **Figure 3**
**Figure 5A** and **Figure 5B** show a bottom view of variations of a detector.
**Figure 6A and 6B** are schematic representations of a detector array and an associated cell array according an embodiment, a schematic representation of a cell of the cell array, and a cell of the cell array according to an embodiment.
**Figure 7** is a schematic representation of a cross-section wiring route showing circuit wires and a shielding arrangement according to an embodiment.
**Figure 8** is a schematic representation of a sensor substrate according to an embodiment.
**Figure 9** is a schematic cross-sectional view of the sensor substrate in **Figure 8****.**
**Figure 10** is a schematic cross-section of a sensor substrate according to an embodiment.
**Figure 11** is a schematic cross-section of a sensor substrate according to an embodiment.

The figures are schematic. The schematic diagrams and views show the members described below. However, the members depicted in the figures are not to scale. Relative dimensions of members in drawings are exaggerated for clarity. Within the following description of drawings the same or like reference numbers refer to the same or like members or entities, and only the differences with respect to the individual embodiments are described.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of substrate, devices (or columns), assemblies, arrays, apparatuses, systems and methods consistent with aspects related to the invention as recited in the appended claims.

The enhanced computing power of electronic devices, which reduces the physical size of the electronic devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one defect can cause electronic device failure. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate signal particles, e.g. secondary electrons and/or back-scatter electrons. The detection apparatus captures the signal particles from the sample as the sample is scanned so that the SEM can create an image of the scanned area of the sample. For high throughput inspection, some of the inspection apparatuses use multiple focused primary beams, i.e. a multi-beam, of primary electrons. The constituent beams of the multi-beam may be referred to as sub-beams or beamlets or an array of primary beams. A multi-beam can scan different parts of a sample simultaneously. A multi-beam inspection (or assessment) apparatus can therefore inspect a sample at a much higher speed than a single-beam inspection (or assessment) apparatus. An implementation of a known multi-beam inspection system is described below.

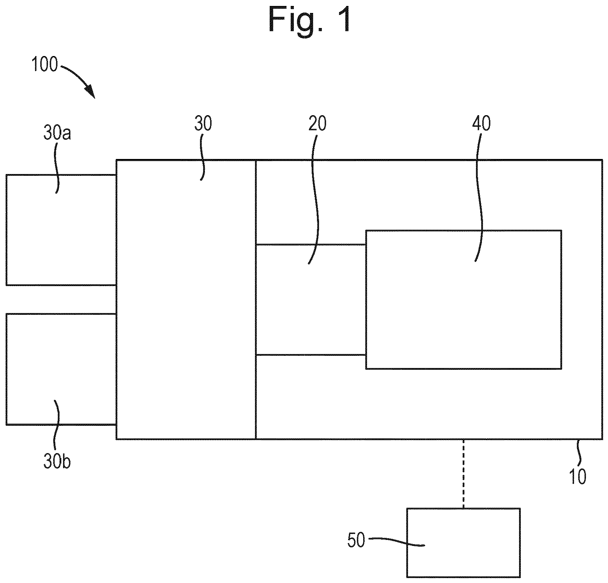

Reference is now made to **Figure 1****,** which is a schematic diagram illustrating an exemplary charged particle beam assessment system 100. The charged particle beam assessment system 100 of **Figure 1** includes a main chamber 10, a load lock chamber 20, an charged particle beam apparatus 40 (which may otherwise be referred to as an electron beam apparatus), an equipment front end module (EFEM) 30 and a controller 50. The charged particle beam apparatus 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. After reaching the first pressure below the atmospheric pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second lower pressure. After reaching the second pressure, the sample is transported to the charged particle beam apparatus 40 by which it may be inspected. Depending on the configuration used, the second pressure may be deeper than between 10⁻⁷ to 10⁻⁵ mbar. An charged particle beam tool 40 may comprise a multi-beam charged particle -optical apparatus.

The controller 50 is electronically connected to the charged particle beam tool 40. The controller 50 may be a processor (such as a computer) configured to control the charged particle beam assessment (e.g. inspection) apparatus 100. The controller 50 may include a processing circuitry configured to execute various signal and image processing functions. While the controller 50 is shown in **Figure 1** as being outside of the structure that includes the main chamber 10, the load lock chamber 20, and the EFEM 30, it is appreciated that the controller 50 may be part of the structure. The controller 50 may be located in one of the members (e.g. elements or components) of the charged particle beam assessment apparatus 100 or it can be distributed over at least two of the members. While the present disclosure provides examples of the main chamber 10 housing a charged particle beam assessment apparatus 100, it should be noted that aspects of the disclosure in their broadest sense are not limited to a chamber housing a charged particle beam assessment apparatus 100. Rather, it is appreciated that the foregoing principles may also be applied to other tools and other arrangements of apparatus, that operate under the second pressure.

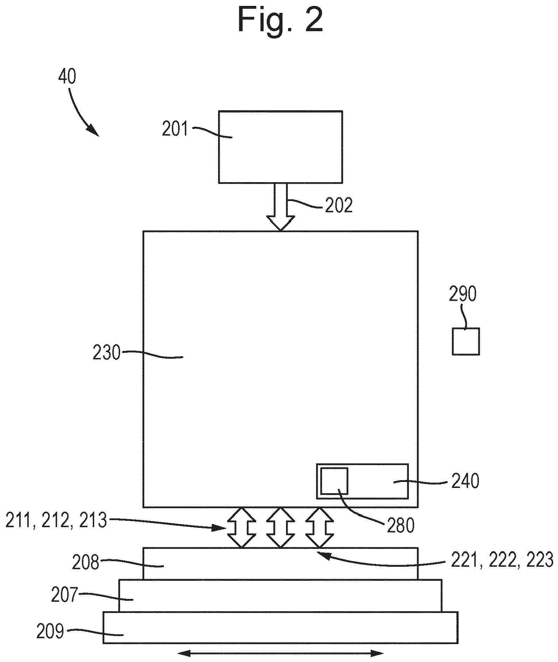

Reference is now made to **FIG. 2****,** which is a schematic diagram illustrating an exemplary charged particle beam tool 40 including a multi-beam inspection tool that is part of the exemplary charged particle beam assessment apparatus 100 of **Figure 1****.** The multi-beam charged particle beam tool 40 (also referred to herein as apparatus 40) comprises an charged particle source 201, a projection apparatus 230, an actuated stage 209, and a sample holder 207. The charged particle source 201 and projection apparatus 230 may together be referred to as an illumination apparatus. Features of the charged particle beam apparatus 40 not including the source 201 and the sample 208, sample holder 207 and actuated stage 209 may together be referred to as a charged particle device 41. The sample holder 207 is supported by actuated stage 209 so as to hold a sample 208 (e.g., a substrate or a mask) for inspection. The multi-beam charged particle beam tool 40 further comprises a detector array 240 (e.g. an electron detection device).

The controller 50 may be connected to various parts of the charged particle beam assessment apparatus 100 of **Figure 1****.** The controller 50 may be connected to various parts of the charged particle beam tool 40 of **Figure 2****,** such as the charged particle source 201, the detector array 240, the projection apparatus 230, and the actuated stage 209. The controller 50 may perform various data, image and/or signal processing functions. The controller 50 may also generate various control signals to govern operations of the charged particle beam assessment apparatus 100, including the charged particle multi-beam apparatus. The controller 50 may control the actuated stage 209 to move sample 208 during inspection of the sample 208. The controller 50 may enable the actuated stage 209 to move the sample 208 in a direction, for example continuously, for example at a constant speed, at least during sample inspection. The controller 50 may control movement of the actuated stage 209 so that it changes the speed of the movement of the sample 208 dependent on various parameters. For example, the controller 50 may control the stage speed (including its direction) depending on the characteristics of the inspection steps of scanning process.

The charged particle source 201 may comprise a cathode (not shown) and an extractor or anode (not shown). During operation, the charged particle source 201 is configured to emit charged particle (e.g. electrons) as primary charged particles from the cathode. The primary charged particles are extracted or accelerated by the extractor and/or the anode to form a primary charged particle beam 202. The charged particle source 201 may comprise multiple sources, such as described in EP20184161.6, which is hereby incorporated by reference at least with respect to the multiple sources and how they relate to multiple columns (or at least multiple charged particle devices) and their associated charged particle-optics.

The projection apparatus 230 is configured to convert the primary charged particle beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets. Furthermore, although the present description and figures relate to a multi-beam system, a single beam system may be used instead in which the primary charged particle beam 202 is not converted into multiple sub-beams. The sub-beams may be generally interchangeable with a single primary charged particle beam 202. For example, a single beam system may be used as described in US 2021/0319977.

The projection apparatus 230 may be configured to focus sub-beams 211, 212, and 213 onto a sample 208 for inspection and may form three probe spots 221, 222, and 223 on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, signal charged particles (e.g. electrons) are generated (i.e. emitted) from the sample 208 which include secondary signal particles and backscatter signal particles. The signal particles emitted from the sample, e.g. secondary electrons and backscatter electrons, may otherwise be referred to as charged particles, e.g. secondary charged particles and backscatter charged particles. Signal beams are formed of signal particles emitted from the sample. It will generally be understood that any signal beams emitted from the sample 208 will travel in a direction with at least a component substantially opposite to the charged particle beams (i.e. the primary beams), or will have at least a component of direction which is opposite to the direction of the primary beams. Signal particles, which are emitted by the sample 208 may also pass through the electrodes of the objective lens and would also be affected by the field.

The detector array 240 is configured to detect (i.e. capture) signal particles emitted from the sample 208. The detector array 240 is configured to generate corresponding signals which are sent to a signal processing system 280, e.g. to construct images of the corresponding scanned areas of sample 208. The detector array 240 may be incorporated into the projection apparatus 230. The detector array may otherwise be referred to as a sensor array, and the terms "detector" and "sensor" and "sensor unit" are used interchangeably throughout the application.

The signal processing system 280 may comprise a circuit (not shown) configured to process signals from the detector array 240 so as to form an image. The signal processing system 280 may otherwise be referred to as an image processing system or a data processing system. The signal processing system may be incorporated into a member of the multi-beam charged particle beam tool 40 such as the detector array 240 (as shown in **Figure 2****).** However, the signal processing system 280 may be incorporated into any members of the inspection apparatus 100 or multi-beam charged particle beam tool 40, such as, as part of the projection apparatus 230 or the controller 50. The signal processing system 280 may be located outside of the structure that includes the main chamber which is shown in **Figure 1****.** The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector array 240 permitting signal communication, such as an electrical conductor, optical fiber cable, portable storage media, IR, Bluetooth, internet, wireless network, wireless radio, among others, or a combination thereof. The image acquirer may receive a signal from the detector array 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary signal particles. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

Known multi-beam systems, such as the charged particle beam tool 40 and charged particle beam assessment apparatus 100 described above, are disclosed in US2020118784, US20200203116, US 2019/0259570 and US2019/0259564 which are hereby incorporated by reference.

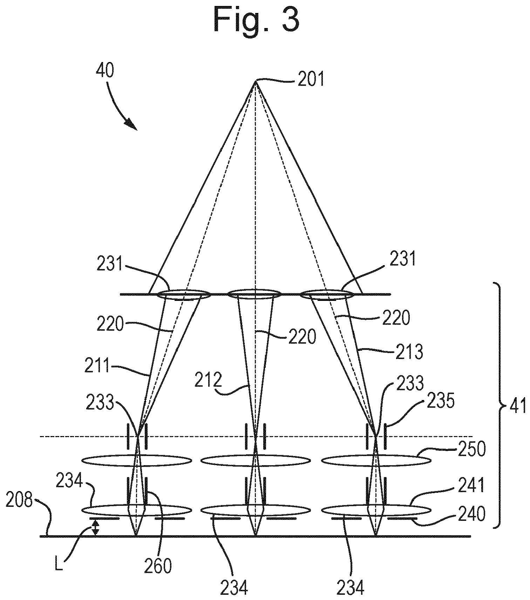

Members (e.g. charged particle components) of a charged particle beam apparatus 40, or charged particle device 41, (of for example an assessment apparatus 100) which may be used in the present invention are described below in relation to **Figure 3** which is a schematic diagram of a charged particle beam apparatus 40. The charged particle beam apparatus 40 of **Figure 3** may correspond to the multi-beam charged particle beam tool (also referred to herein as apparatus 40).

The charged particle source 201 directs charged particles (e.g. electrons) toward an array of condenser lenses 231 (otherwise referred to as a condenser lens array) forming part of the projection system 230. The charged particle source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The array of condenser lenses 231 may take the form of at least two plates, acting as electrodes, with an aperture in each plate aligned with each other and corresponding to the location of a sub-beam. At least two of the plates are maintained during operation at different potentials to achieve the desired lensing effect.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. which is herein incorporated by reference at least so far as the features of an objective lens array disclosed therein. There may be some variation for optimizing aberration corrections as described in EP Application 20207178.3 filed on 12 November 2020, for example in figure 12, which is herein incorporated by reference at least with respect to corrections achieved by varying aperture diameter.

Voltage sources (which may be provided by individual electric power sources, or may all be supplied by electric power source 290) may be used to apply potentials to at least one electrode of the objective lens array 241, at least one electrode of the control lens 250 and/or to the sample to control projection of the primary beam(s) through the objective lens array 241, as described in EP Application 20207178.3 filed on 12 November 2020, for example in figure 14, and in EP 21174518.7 filed 18 May 2021. Variation in the potentials can be used for different landing energies, to control the beam opening angle and/or the focus of the primary beam on the sample. The potentials may be controlled to accelerate or decelerate the primary beam through the objective lens array 241 towards the sample.

The detector array 240 (which may otherwise be referred to as an array of detectors) comprises a plurality of detectors. Each detector is associated with a corresponding sub-beam (which may otherwise be referred to as a beam or primary beam). In other words, the arrays of detectors (i.e. the detector array 240) and sub-beams correspond. Each detector may be assigned to a sub-beam. The array of detectors may correspond with the array of objective lenses. In other words, the array of detectors may be associated with the corresponding array of objective lenses. A detector array 240 is described below. However, any reference to detector array 240 may be replaced with a single detector (i.e. at least one detector) or multiple detectors as appropriate. The detectors may otherwise be referred to as detector elements 405 (e.g. sensor elements such as capture electrodes). The detectors may be any appropriate type of detector. A detector may be a type of charged particle optical component.

The detector array 240 may be positioned at a position along the primary beam path at any location between an upper beam position and a lower beam position along the beam path. The upper beam position is above the objective lens array and optionally any associated lens arrays such as a control lens array (i.e. up beam of an objective lens array assembly). The lower beam position is down beam of the objective lens array. In an arrangement the detector array may be an array that is up beam of the objective lens array assembly. The detector array may be associated with any electrode of the objective lens array assembly. Reference hereafter of a detector in association with an electrode of the objective lens array may correspond to an electrode of the objective lens array assembly, except for the most down beam surface of the most down beam electrode of the objective lens array, unless stated explicitly otherwise.

In an arrangement the detector array 240 may be positioned between the control lens array 250 and the sample 208. The detector array 240 may be positioned between the objective lenses 234 and the sample 208, as shown in **Figure 3****.** Although this may be desirable, the detector array 240 may be provided in additional or alternative locations. Multiple detector arrays may be provided in a variety of locations.

The detector array 240 may be positioned proximate and/or adjacent the sample. The detector being proximate and/or adjacent the sample enables the risk of cross-talk in detection of signal particles generated by sub-beams which correspond to another detector in the detector array to be reduced if not avoided.

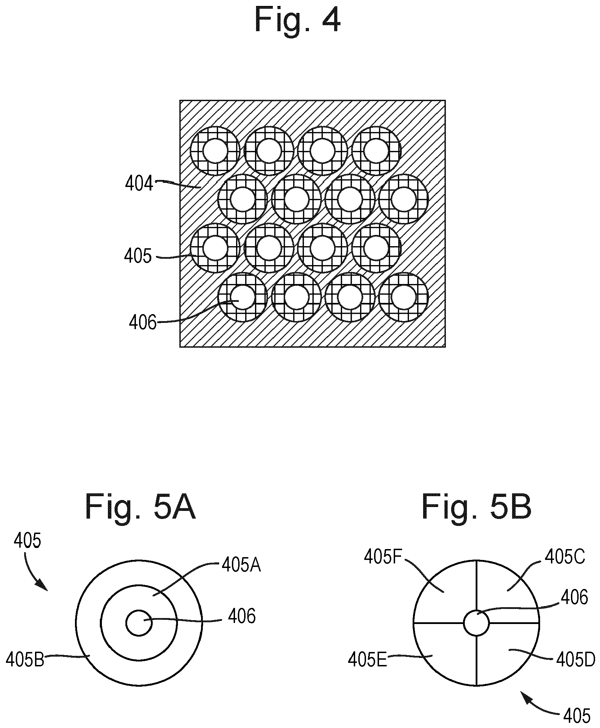

**Figure 4** is a bottom view (i.e. a plan view) of detector array 240 which comprises a substrate 404 on which are provided a plurality of detector electrodes 405 each surrounding a beam aperture 406. The beam apertures 406 may be formed by etching through substrate 404. In the arrangement shown in **Figure** 4, the beam apertures 406 are shown in a hexagonal close packed array. The beam apertures 406 can also be differently arranged, e.g. in a rectangular array. The detector electrodes 405 are isolated from each other by a gap between the detector electrodes 405. Furthermore, the substrate 404 isolates the detector elements 405 from each other, and may otherwise be referred to as an isolating element.

The detector array 240 may be within a certain distance of the sample 208, e.g. close to the sample. The at least one detector may be positioned in the device 41 so as to face the sample. Thus, the at least one detector may be configured to face towards a sample support configured to support the sample 208, e.g. the sample holder 207. That is the detector may provide a base to the device 41. The detector as part of the base may face a surface of the sample. The base may have a cross-section having a cross-sectional area and may be referred to as a sample facing surface. (In some types of assessment apparatus in which the charged particle device may be comprised, the sample facing surface may be referred to as a microscope base, or head).

-For example, the at least one detector array may be provided on an output side of the objective lens array 241. The output side of the objective lens array 241 is the side on which the sub-beams are output from the objective lens array 241, i.e. the bottom or downbeam side of the objective lens array in the configuration shown in **Figure 3****.** In other words, the detector array 240 may be provided downbeam of the objective lens array 241. The detector array 241 may be an integral feature of the objective lens array 241. The detector and objective lens may be part of the same structure. The detector may be connected to the lens by an isolating element or directly to an electrode of the objective lens. Thus, the at least one detector may be part of an objective lens assembly comprising at least the objective lens array and the detector array. If the detector array is an integral feature of the objective lens array 241, the detector array 240 may be provided at the base of the objective lens array 241. In an arrangement the detector array 240 may be integral to the most-down-beam positioned electrode of the objective lens array 241.

Desirably, a distance 'L' as shown in **Figure 3****,** between the detector array 240 and the sample 208 is between approximately 20 to 100 µm, i.e. the detector array 240 is positioned within approximately 20 to 100 micron for example from the sample 208. Generally the distance L is small so to ensure detector efficiency and/or reduce cross-talk, for example between 5 and 200 micron. The distance L is determined as the distance from a surface of the sample 208 facing the detector array 240 and a surface of the detector array 241 facing the sample 208.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the tool and can be swapped between operable and non-operable positions without opening the tool.

In some embodiments, one or more aberration correctors are provided that reduce one or more aberrations in the sub-beams. The one or more aberration correctors may be provided in any of the embodiments, e.g. as part of the charged particle-optical device 41, and/or as part of an optical lens array assembly, and/or as part of an assessment tool. In an embodiment, each of at least a subset of the aberration correctors is positioned in, or directly adjacent to, a respective one of the intermediate foci (e.g. in or adjacent to the intermediate image plane). The sub-beams have a smallest cross-sectional area in or near a focal plane such as the intermediate plane. This provides more space for aberration correctors than is available elsewhere, i.e. up beam or down beam of the intermediate plane (or than would be available in alternative arrangements that do not have an intermediate image plane).

In an embodiment, aberration correctors positioned in, or directly adjacent to, the intermediate foci (or intermediate image plane) comprise deflectors to correct for the source 201 appearing to be at different positions for different sub-beams. Correctors can be used to correct macroscopic aberrations resulting from the source that prevent a good alignment between each sub-beam and a corresponding objective lens.

The aberration correctors may correct aberrations that prevent a proper column alignment (or alignment of charged particle members along the beam path of a charged particle device from source to sample position). Such aberrations may also lead to a misalignment between the sub-beams and the correctors. For this reason, it may be desirable to additionally or alternatively position aberration correctors at or near the condenser lenses 231 (e.g. with each such aberration corrector being integrated with, or directly adjacent to, one or more of the condenser lenses 231). This is desirable because at or near the condenser lenses 231 aberrations will not yet have led to a shift of corresponding sub-beams because the condenser lenses are vertically close or coincident with the beam apertures. The condenser lenses and correctors may be part of the same structure. For example they may be connected to each other, for example with an electrically isolating element. The aberration correctors may be CMOS based individual programmable deflectors as disclosed in EP2702595A1 or an array of multipole deflectors as disclosed EP2715768A2, of which the descriptions of the sub-beam manipulators in both documents are hereby incorporated by reference.

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used.

In an embodiment, a single detector element 405 surrounds each beam aperture 406. In another embodiment, a plurality of detector elements 405 are provided around each beam aperture 406. Thus, the detector comprises multiple portions, and more specifically, multiple detecting portions. The plurality of detector portions may, together, have a circular perimeter and/or a diameter. The plurality of detector portions may, together, have an area extending between the aperture and the perimeter of the plurality of detector portions. The different portions may be referred to as different zones. Thus the detector may be described to have multiple zones or detection zones. Such a detector may be referred to as a zoned detector. The signal particles captured by the detector elements 405 surrounding one beam aperture 406 may be combined into a single signal or used to generate independent signals. The surfaces of the detector elements, optionally their detector portions, may substantially fill the surface of the substrate supporting the detector elements. The detector comprising multiple portions may be provided in any of the detector arrays described herein.

The zoned detector may be associated with one of the sub-beams 211, 212, 213. Thus, the multiple portions of one detector may be configured to detect signal particles emitted from the sample 208 in relation to one of the sub-beams 211, 212, 213. The detector comprising multiple portions may be associated with one of the apertures in at least one of the electrodes of the objective lens assembly. More specifically, the detector 405 comprising multiple portions may be arranged around a single aperture 406 as shown in **FIG 5A** and **FIG 5B****,** which provide examples of such a detector.

The portions of the zoned detector may be separated in a variety of different ways, e.g. radially, annular, or any other appropriate way. Desirably the portions are of similar angular size and/or similar area and/or similar shape, for example as shown in **FIG 5B****.** The separated portions may be provided as a plurality of segments, a plurality of annular portions (e.g. a plurality of concentric annuli or rings), and/or a plurality of sector portions (i.e. radial portions or sectors). The detector elements 405 may be divided radially. For example, the at least one detector 405 may be provided as annular portions comprising 2, 3, 4, or more portions. More specifically, as shown in **Figure 5A****,** the detector 405 may comprise an inner annular portion 405A surrounding aperture 406 and an outer annular portion 405B, radially outwards of the inner annular portion 405A. Alternatively, the detector elements 405 may be divided angularly. For example, the detector may be provided as sector portions comprising 2, 3, 4, or more portions, for example 8, 12 etc.. If the detector is provided as two sectors, each sector portion may be a semi-circle. If the detector is provided as four sectors, each sector portion may be a quadrant. This is shown in **Figure 5B** in which the 405 is divided into quadrants, i.e. four sector portions is shown in **Figure 5B****,** as described below. Alternatively, the detector may be provided with at least one segment portion. The electrode elements may be separated both radially and angularly (e.g. in a dart board arrangement) or in any other convenient manner.

Each portion may have a separate signal read-out. The detector being separated into portions, e.g. annular portions or sector portions, is beneficial in that it allows more information to be obtained in relation to the signal particles detected. Thus, providing the detector 405 with multiple portions may be beneficial in obtaining additional information relating to the detected signal particles. This can be used to improve the signal to noise ratio of the detected signal particles. However, there is an additional cost in terms of the complexity of the detector.

As shown in **Figure 5A****,** the detector, in which an aperture 406 is defined and configured for the through passage of a charged particle beam, comprises inner detecting portion 405A and outer detecting portion 405B. The inner detecting portion 405A surrounds the aperture 406 of the detector. The outer detecting portion 405B is radially outwards of the inner detecting portion 405A. The shape of the detector may be generally circular. Thus, the inner detecting portion and the outer detecting portion may be concentric rings. In an example, the detector may be divided into two (or more) concentric rings, for example, as depicted in **FIG 5A****.**

Providing multiple portions concentrically or otherwise may be beneficial because different portions of the detector may be used to detect different signal particles, which may be smaller angle signal particles and/or larger angle signal particles, or secondary signal particles and/or backscatter signal particles. Such a configuration of different signal particles may suit a concentrically zoned detector. The different angled backscatter signal particles may be beneficial in providing different information. For example, for signal particles emitted from a deep hole, small-angle backscatter signal particles are likely to come more from the hole bottom, and large-angle backscatter signal particles are likely to come more from the surface and material around the hole. In an alternative example, small-angle backscatter signal particles are likely to come more from deeper buried features, and large-angle backscatter signal particles are likely to come more from the sample surface or material above buried features.

Any appropriate variation in the apparatus may be implemented. For example, the macro-collimator may be partially or wholly replaced by a collimator element array provided down-beam of the upper beam limiter. For example, a macro scan deflector 265 may be provided to cause sub-beams to be scanned over the sample 208. For example, the macro scan deflector 265 may be partially or wholly replaced by a scan deflector array.

In other embodiments both a macro scan deflector 265 and the scan-deflector array are provided. In such an arrangement, the scanning of the sub-beams over the sample surface may be achieved by controlling the macro scan deflector and the scan-deflector array 260 together, desirably in synchronization.

The invention can be applied to various different tool architectures. For example, the charged particle beam tool 40 may be a single beam tool, or may comprise a plurality of single beam columns (or single beam devices 41) or may comprise a plurality of columns of multi-beams (i.e. sub-beams). The columns may comprise, or even be, the charged particle optical device 41 described in any of the above embodiments or aspects. As a plurality of columns (or a multi-column tool), the devices may be arranged in an array which may number two to one hundred columns or more. The charged particle optical device may be a charged particle optical column. A charged particle column may optionally comprise a source.

If multiple detector arrays are provided, they may be configured to detect signal particles simultaneously. The detectors may be positioned to face up-beam of the primary beam paths 320. In other words, the detectors may be configured to face along the primary beam path 320 towards a source of the primary beam (described above as source 201), i.e. away from the sample 208. The detectors may be configured to face towards the sample, i.e. in the direction of the sample 208. In other words, the detectors may be facing in a direction along the primary beam path 320 towards the sample 208, i.e. away from the source.

Any of the detector arrays may be associated with (e.g. in, on, positioned adjacent to, connected to, or integrated with) at least one electrode of the objective lens array 241 (e.g. either an up-beam electrode or a down-beam electrode). For example, the array of detectors may be in or on at least one electrode of the objective lens array 241. For example, the array of detectors may be positioned adjacent to one of the electrodes. In other words, the array of detectors may be positioned in close proximity and next to one of the electrodes. For example, the array of detectors may be connected (e.g. mechanically connected) to one of the electrodes. In other words, the array of detectors may be attached to one of the electrodes, e.g. by adhesive or welding or some other attachment method. For example, the array of detectors may be integrated with the one of the electrodes. In other words, the array of mirror detectors may be formed as part of one of the electrodes.

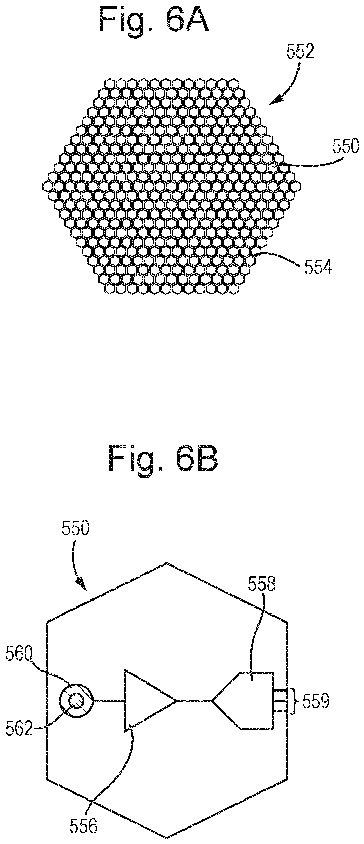

As shown in **Figure 6A** a surface of a detector array or detector module (desirably facing, even proximate in use to, a sample) features an array of detector elements (or an array of detectors). Each detector element is associated with an aperture. Each detector element is associated with an assigned surface area of the substrate of the detector module . As the substrate is layered, for example in having a CMOS structure, each layer within the substrate is positioned with respect to the respective detector elements, desirably proximately. Commercially available CMOS structures have a usual range of layers, for example three to ten, usually about five. (For example, two functional layers may be provided for ease of description, which may be referred to as circuitry layers. These two layers of wiring layer and logic layer may represent as many layers as required and each layer is not restricted to wiring or logic, respectively.) The number of layers is limited by commercial availability and any number of layers is feasible. However, in view of practicality, the substrate has a limited number of layers, in order for an efficient design the available space is limited.

Ideally a circuit layer of the substrate, which can be the wiring layer and/or logic layer, has a portion assigned for each detector element (or detector). The assigned portions of the different layers may be referred to as a cell 550. The arrangement of portions in the substrate for the full multi-beam arrangement may be referred to as a cell array 552. The cells 550 may be same shape as the surface area assigned for each detector element, such as hexagonal, or any reasonable shape that may tesselate and may all be similar in shape and/or area, such as a rectangular shape. Having a rectangular or rectilinear shape can more readily be used by placing and routing design. Such design is commonly implemented by software that is suited to define chips with an rectangular type architecture with orthogonal directions, than architecture requiring acute or obtuse angles such as in a hexagonal architecture. In **FIG 6A** the cells 550 are depicted as being hexagonal and the cell array 552 is depicted as a hexagon comprising individual cells. However, ideally each similarly located with respect to detector elements. Wiring routes 554 may connect to each cell 550. The wiring routes 554 may be routed between other cells of the cell array 552. Note: reference to wiring routes to be between cells of the array, it is intended that at least the wiring routes avoid the beam apertures of the array of apertures, e.g. defined through the cell array. In an arrangement circuit architecture, the cell size in at least the circuit layer may be reduced to accommodate the wiring routes, so that the wiring routes are routed between cells. Additionally or alternatively the wiring routes pass through the cells of the cell array, desirably towards the perimeter of the cells for example to reduce the interference of the wiring routes with other circuitry in the cells. Therefore reference to a wiring route between the cells encompasses: a wiring route between the circuitry of cells, a wiring route within cells, desirably towards the periphery of the cells and at least around the beam apertures through the cells and any intermediate variation. In all these arrangements, for example in a CMOS architecture, the wiring routes may be in the same die as the other circuitry which may define circuitry in the same cell as a portion of the wiring route, or circuitry in a cell around which the wiring route is routed. Thus, the cells and wiring routes may parts of a monolithic structure. The wiring routes 554 may signally connect the cells. Thus the wiring routes signally connect the cells 550 to a controller or data processor external to the cell array or even the substrate or detector module. The circuit layer may comprise a datapath layer for the transmission of sensor signals from a cell outward of the cell array.

The controller or data processor may before circuitry within the substrate or detector module, desirably external to the cell array for example as control and I/O circuitry (not shown). The control and I/O circuitry may be in the same die as the cell array; the control and I/O circuitry may be monolithically integrated with the cell array, for example in the same CMOS chip. The control and to I/O circuitry enables an efficient connection between the data from all the cells of the cell array 552. Consider for example an arrangement of around 3000 cells each having an 8 bit digital output. Such an arrangement would have around 22000 signals to the electronics located outside the CMOS chip. The standard way of doing this is to use a SERDES circuitry (serializer / de-serializer). Such circuitry would transform a large number of low data rate signals into a few number of high data rate signals by means of time division multiplexing. It is therefore beneficial to have control and I/O circuitry monolithically with the cell array, or at least in the detector module, than external to the detector module.

In embodiments the control and I/O circuitry may feature general supporting functions, such as circuitry to communicate with the electronics outside the CMOS chip to enable loading certain settings, for example for control of amplification and offset such as subtraction as described herein.

The circuit layer of a cell 550 is connected to a detector element of the respective cell. The circuit layer comprises circuitry having amplification and/ digitation functions, e.g. it may comprise a amplification circuit. Such a circuitry associated with the detector, e.g. in a cell, may comprise elements to process a detection signal detected by the respective detector element. Such circuitry may be considered to process the detection signal. Such circuitry may be referred to as a detector processing circuitry. A cell 550 may comprise a trans impedance amplifier (TIA) 556 and an analogue to digital converter (ADC) 558 as depicted in **Figure 6B****.** A cell may comprise the detector processing circuitry associated with a detector element. This figure schematically depicts a cell 550 with an associated detector element such as capture electrode and a feedback resistor 562 connected to the trans impedance amplifier 556 and the analogue to digital converter 558. The digital signal lines 559 from the analogue to digital converter 558 leave the cell 550. Note that the detector element is represented as a detector element 560 and feedback resistor is shown associated with the detector area as a disc 562 rather than associated with the trans impedance amplifier 556. This schematic representation is to represent each of the detector element and the feedback resistor as an area to indicate their relative size.

The trans impedance amplifier may comprise a feedback resistor Rf 562. The magnitude of the feedback resistor Rf should be optimized. The larger the value of this feedback resistor, the lower the input referred current noise. Thus the better signal-to noise ratio at the output of the transimpedance amplifier. However, the larger the resistance, Rf, the lower the bandwidth. A finite bandwidth results in a finite rise and fall time of the signal, resulting in additional image blur. An optimized Rf results in a good balance between noise level and additional image blur.

To implement the design the circuitry i.e. the amplification circuitry associated with each detector element should be within the layers of the associated cell 550 and fit in the limited area available of the portions of each associated layer. A typical resistance of the feedback resistor Rf can be as high as 30 to 300MOhm. If such a resistor would be implemented as a poly resistor in a standard CMOS process the size of such resistor would be much larger than the area that is available in the CMOS layers of the cell 550. For example, a resistor of 300MOhm would consume around 500000 micron^2. This is about 130 times larger than the entire available area.

Typically, for example in CMOS architecture, such a large resistor would be made in a single layer for example of polysilicon. Usually there is a single layer of polysilicon. In some circumstances a layer may be provided having material capable of providing high resistor values, although with such a high aspect ratio (e.g. extreme length relative to width of the resistive structure in the layer) the reliability of the resistor remains. Even if the cell were to have multiple layers used for such a resistor, many more layers would have to be present than is readily available for example using CMOS technology. Additionally or alternatively, the meandering path through different layers would not mitigate the high aspect ratio and risk of variation in the resistance value would only be contributed by the interconnections between different layers. Such interconnects influence the variability of the resistance value of a resistor as a corner, as later described herein.

Note that such dimensions are calculated assuming a 180 nm technology node. Using 180 nm technology node is preferred to a smaller node for processing reasons. For instance interconnects in a 180 nm node are simpler to process.

Further if such a resistor were made, in whichever node, the reliability of the resistor specifications as well as the space available for the resistor may be challenging.

In a layered structure for chip architecture, such as CMOS, the members and features are defined as structures in a layer. The specification of a member is dependent on the material of the layer and the physical properties of the layer, the dimensions of the layer, specifically its thickness and the dimensions of the structure formed in the layer. A resistor may take the form of a long narrow path, route or wire. In view of space constraints, the path may be non-linear, having corners along its path. For such a long member, the width of the path in the layer may vary such as through manufacturing tolerances. A corner may provide greater variance than a linear section of the path, limiting the accuracy with which the resistor can be made in order to have a specified resistance. With many corners and a long length, a resistor having such topology may made with poor reliability so that the resistances for equivalent resistors in different cells of the cell array may have a large range.

Such a resistive structure has a large surface area. Additionally or alternatively, a resistor with such a large surface area would additionally have a capacitance which is undesirable; such a capacitance is referred to as a parasitic capacitance. Parasitic capacitances may undesirably contribute to noise and blur, influencing the balance between noise, blur and bandwidth optimization which is elsewhere herein described

The material properties of the layer can be modified chemically; however such modifications are unlikely to achieve the improvement of several orders of magnitude in size to fit into available space in the cell. Such modifications are unlikely to change the topography of the feedback resistor sufficiently so that has the required specification and can be made with the desired reliable accuracy.

Such requirements in reliability and size would enable the resistor to achieve its desired performance in terms of bandwidth, signal to noise ratio, and stability. Unfortunately these requirements cannot be met.

Alternative amplification circuitry is proposed which does not require such a large feedback resistor. Examples include a trans impedance amplifier with a pseudo resistor as a feedback element and a direct analogue to digital converter, obviating the need for a transimpedance amplifier. Two examples of a direct analogue to digital converter are: using a low duty cycled switched resistor, and using a reference capacitor. These examples are described in detail in European Application No. 20217152.6 filed on 23 December 2020 (WO2022008462), which is hereby incorporated by reference, particularly in relation to the use of a low duty cycled switched resistor and a reference capacitor. An optional arrangement is to remove the analogue to digital converter 558 from the cells 550 so that a circuit wire 570 connects the trans impedance amplifier 556 in the cell 550 with the analogue to digital converter external to the cell array 552, as described in European Application No. 20217152.6 filed on 23 December 2020 (WO2022008462). By removing the analogue to digital converter from the cell 550, there is more space available in the circuit layer of the cell 550 for a feedback resistor element. There is yet more space in the circuit layer of the cell 550 if the amplifier circuitry uses an alternative trans impedance amplifier circuit, for example if a trans impedance amplifier with a pseudo resistor is used as a feedback element. The example amplifier circuits described are just some of the suitable types of amplification circuitry that can be used. Other amplifier circuits may exist which achieve similar benefits to those described herein and which use similar circuit architecture for each cell as herein described.

Although it may be easier to fit the trans impedance amplifier 556 with a pseudo resistor feedback element and analogue to digital converter in the circuit layers of the cell, in an arrangement it is more practical for space constraints for the analogue to digital converter 558 to be external to the cell array 552. This is despite the use of a pseudo resistor in the feedback element of the trans impedance amplifier providing a gain of one to two orders of magnitude in area. One consideration to decide whether or not the analogue to digital converter 558 is external to the cell array 552 is the sub-beam pitch of the multi-beam. For example with a sub-beam pitch of between 50 and 100 micron, typically only 4000 square micron is available per layer of a cell for the circuitry including the amplification circuitry.

Under such space constraints, a trans impedance amplifier is located in the cell of each beam. The analogue to digital converter is located outside the array of sub-beams, i.e. outside the cell array. In an embodiment, the analogue to digital converter is present on the same die as the cell array, for example monolithically with the cell array. Such an analogue to digital converter may be located with the control and I/O circuitry which may be on the detector module or even monolithic with the cell array 552. Locating the analogue to digital converter external to the cell array may provide an area gain of about a factor of two.

The circuit wire 570 connects the trans impedance amplifier in a cell 550 with the associated analogue to digital converter 558. The circuit wire 570 transmits an analogue signal. Unlike a digital signal, a data path transmitting an analogue signal is susceptible to interference. Signal interference can be from cross-talk with other circuit wires and from external fields such as generated by the sub-beams of the multi-beam and fields from nearby charged particle optical members such as the objective lens array 241.

The circuit wire 570 is routed through the a wiring route 554 as depicted in **Figure 6A****.** The wiring route 554 is routed between cells so that the area of a cell and its layers is used for the amplification circuitry present on a cell. The wiring route 554 therefore only uses a portion of the circuit layers in which the wiring route is present, namely between adjoining cells 550 (e.g.. at least around the beam apertures 504, 406 of the adjoining cells 550; through the adjoining cells 550 such as towards the periphery of the cells or between the circuitry in a layer assigned to the adjoining cells 550, or any arrangement between the stated arrangements). This routing avoids architectural interference of the amplification circuitry and the architecture of the wiring routes 554. Circuit wires are routed along the wiring routes in the cell array in an outward direction, for example in a radially outward direction. With greater proximity to a perimeter of the cell array 552, there may be more circuit wires 570 than in a portion of the wiring route 554 remote from the perimeter. The wiring route may have a plurality of circuit wires 570, which as described, is between cells of the array. Therefore a portion of the wiring route 554 may have more than one circuit wire 570. However, having circuit wires located close to each other risks crosstalk between the circuit wires and interference of the analogue signals transmitted by the circuit wires 570.

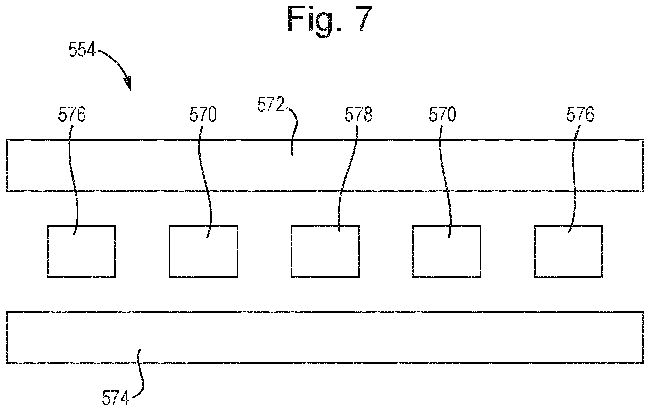

The risk of crosstalk and signal interference may be at least reduced or even prevented by having the circuit wires 570 shielded from each other within the wiring route. **Figure 7** depicts cross-section of an exemplary arrangement of wiring route 554. Within the wiring route 554 are one or more circuit wires 470, shown extending in same direction as the wiring route 554 and a shielding arrangement. The circuit wires are shown in the same layer. Above the circuit wires 570 is an upper shielding layer 572; beneath the circuit wires 570 is a lower shielding layer 574 (or more down-beam shielding layer 574). The upper and lower shielding layers of the shielding arrangement shield the circuit wires 570 from fields external to the wiring route 554 above and beneath the wiring route 554. The shielding arrangement has shielding elements in the same layer as the circuit wires 570. The shielding elements may be outer elements 576 at the outer edges of the layer comprising the circuit wires 570. The outer elements 576 shield the circuit wires 570 from fields external to the wiring route 554. The shielding elements may include intermediate shielding elements 578 that are present in the layer between adjoining circuit wires. The intermediate shielding elements 578 may therefore at least suppress if not prevent cross-talk between the circuit wires 570. In operation, a common potential is applied to the shielding layers 572, 574 and shielding elements 576, 578. The potential may be a reference potential for example a ground potential.

Although **Figure 7** depicts a three layer arrangement, as many layers may be used in the wiring route 570 as may be desired. For example, there may be two layers of circuit wires, requiring three shielding layers which include an upper shielding layer 572, a lower shielding layer 574 and an intermediate shielding layer. The intermediate shielding layer may additionally reduce if not prevent crosstalk between the circuit wires in the different layers of the wiring route 570. Thus, there are five layers in total. Every additional layer of circuit wires requires an additional intermediate shielding layer. Whereas increasing the number of layers in the wiring route 554 reduces the proportion of a layer that wire routing requires, such a variation in design requires additional layers. In view of the limited number of layers, there is an optimum number of layers at which the width of the wiring route is reduced without exceeding the number of layers required elsewhere in the substrate of the detector module, which can be limited to five layers.

A further consideration of the design of wiring route is the number of circuit wires that may need to be present in an exemplary design of detector module, for example consider the arrangement of **Figure 7** with all circuit wires 570 in a layer.

For example, an array of sub-beams is arranged an hexagonal array with thirty (30) rings of sub-beams, for example arranged concentrically. The detector module therefore has a cell array of corresponding design. The number of cells is around 3000. Such a cell array may have a pitch of fifty to two hundred micron.

The outermost ring has the highest number of signals that need to be routed through the ring. Considering the wiring route is routed between cells of the cell array, all the signals of the cells are routed through the outermost ring, between the cells of the outermost ring. In this example the outermost ring consists of 180 cells, so the number of signals transported through the outermost ring, e.g. between the cells of the outermost ring, is approximately 2600. Thus, the maximum number of signals to be routed through the outer ring between adjacent cells is the total number of signals divided by the number of cells in the outermost ring (e.g. around 180). This is fifteen 15 (rounded up to the nearest whole number). Since the wiring route has a shielding arrangement to ensure that the signals are well shielded, e.g. limiting crosstalk and the influence of external fields, there may be sixteen shielding elements, including fourteen (14) intermediate shielding elements and two outer shielding elements 576. Therefore between adjacent cells 550 of the outer ring of the example, a wiring route having all circuit wires in the same layer would have thirty-one (31) elements of alternate shielding elements and circuit wires.

For cell array 552 for a beam array with a pitch of between 50 and 100 microns, there is enough space, or area, available in the circuit layer, for such a wiring route 554. In a structure created using a process at the 180nm node, the minimum half pitch of a metal layer is typically around 280nm. In this context a half pitch is a line and a pitch is the line with an associated gap with an adjoining gap. The associated gap is typically the same width the line. The wiring route for thirty-one elements requires thirty-one pitches. However, the associated gap of one of the elements, that corresponds to the outer elements 576, is not part of the wiring route 554, but would separate the wiring route from adjoining circuitry. Therefore, for thirty one elements, sixty-one (61) half pitches are required, which corresponds to a width of the circuit wiring 554 of approximately 17.1 micrometers.

The optimization of the noise performance for example in terms of bandwidth and noise optimization and balance between the blur and the noise can be enabled by making sure an amplification factor of the trans impedance amplifier is programmable. In a such an arrangement, the amplifier circuit of the cell, at least the trans impedance amplifier, is programmable. Such a programmable amplification circuit may comprise a variable amplifier and/or a variable analogue to digital converter for example. in terms of its sensitivity.. The variable amplifier has a variable amplification range dependent on a detected beam current detected by a detector element 503. For example, when the detected beam current is low, or for a sample with a lower than typical secondary emission coefficient, the variable amplifier can be adjusted to provide a larger amplification than normally used. When a larger beam current than normal is detected by a detector element 503, or for a sample with a larger than typical secondary emission coefficient, the variable amplifier can be tuned to provide a smaller amplification.

This functionality is beneficial with a trans impedance amplifier with a feedback element having pseudo resistor. A pseudo resistor has different effective resistances on application of different applied voltages; unlike an ideal resistor which has a single resistance at all applied potential differences. In providing different resistance, the trans impedance amplifier associated with the pseudo resistor operates as a variable amplification. In providing an amplifier with variable functionality, an optimized balance between noise levels and image blur (referred to herein above as 'additional blur') may be achieved. Beneficially, the programmable amplification circuit may match the output of the trans impedance amplifier with the input of the analogue to digital converter. This may be as a programmable offset that is subtracted between the output of the trans impedance amplifier, and the input of the analogue to digital converter. The programmable offset may help reduce the required number of bits that need to be transmitted from the amplification circuit of a cell. The programmable offset may be implemented in the programmable amplifier. These measures help to ensure that the dynamic range of the trans impedance amplifier and the analogue to digital converter, and thus desirably the amplification circuit, are optimally used for different use cases. Such different use cases may include: the material properties of a sample under inspection, different assessment tool configurations for example using different beam currents. The range of applications may be enabled by the provision of a variable amplifier and a variable off set or threshold (e.g. subtraction by a programmable offset) desirable enables tuning of amplification, threshold and bandwidth As mentioned elsewhere herein, the circuitry associated with variable amplification and subtraction may be comprised in the control and I/O circuitry.

In known systems, primary charged particles are projected onto a sample (e.g. a wafer) through a set of lenses and a detector, for example, as described above. The signal charged particles that are emitted from the sample as a result of the primary charged particles incident on the surface of the sample may be detected by the detector, which can convert the detection of the charged particles into an electrical signal. The electronic signal may be transformed into an image of the substrate. Desirably, the charged particle detector is positioned proximate and parallel to the sample surface, for example, in the order of micrometers. To ensure the charged particle detector remains at a suitable and safe level above the sample, at least one distance sensor may be used to measure the distance between the sample and the charged particle detector surface. The distance sensors may be referred to as z-sensors, referring to the axis of the coordinate frame generally used to measure distance between the sample and the charged particle detector.

In known systems, at least one distance sensor is implemented as part of at least one additional module with its own mechanical housing and its own read-out electronics. Accommodating the distance sensor near and around the charged particle detector takes up valuable space in the critical area around the charged particle detector and above the sample. This limits the implementation of other systems or other detectors in the vicinity of the charged particle detector. Furthermore, due to the fact the distance sensor is a mechanically separate item, the exact alignment and control of mechanical tolerances between distance sensor and the charged particle detector is an additional requirement to fulfill in production and assembly.

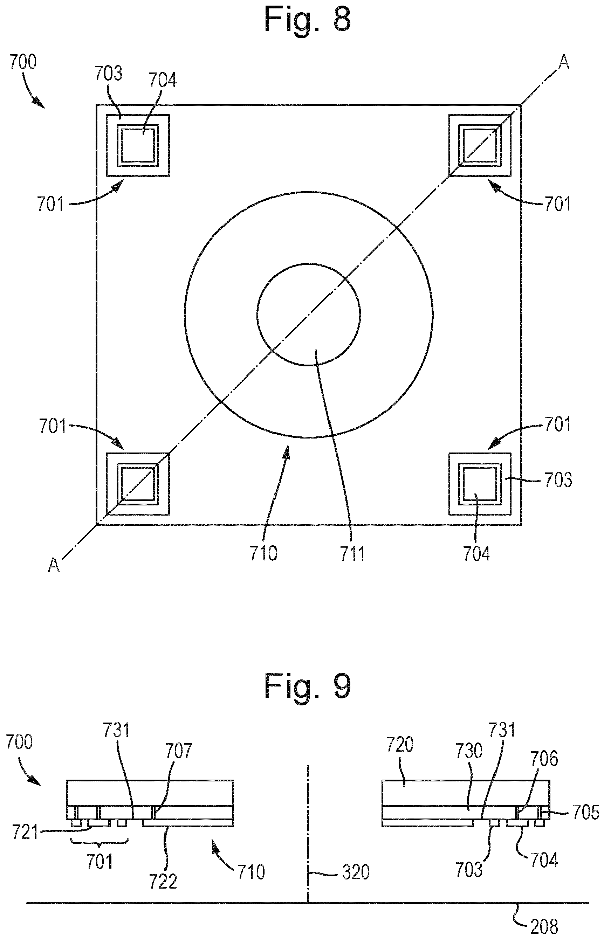

In an embodiment, a sensor substrate for a charged particle assessment apparatus is provided, for example as shown in **Figure 8****.** The sensor substrate 700 may otherwise be referred to as a detector chip, or even a CMOS detector chip if it has a CMOS structure as described above for example in relation to **Figures 6A, 6B** and/or **7.**

The sensor substrate 700 comprises a plurality of distance sensors 701. Each of the distance sensors 701 are configured to generate a measurement signal representative of a distance between the distance sensor 701 and a facing surface of a target. Thus, the distance sensors 701 can be used to measure a distance to a target. Desirably, the target is the sample 208 as shown in **Figure 9****.**

Providing the distance sensors 701 as part of the sensor substrate 700 means the distance sensor 701 is incorporated into, and is part of, the sensor substrate 700. Thus, constituent features (i.e. parts) of the distance sensors 701 can be provided within the sensor substrate 700, i.e. within the structure of the sensor substrate 700. For example, as described further below, any isolating and/or circuitry elements which may be part of the distance sensor 701 can be formed within, or at least as part of, the sensor substrate 700. The sensing substrate 700 may comprise several members (e.g. several components) but may be a single monolithic structure. Thus, the members of the sensor substrate 700 may be integral to, i.e. incorporated within, the structure.

As the distance sensors 701 are part of the sensor substrate 700, this allows the distance measurement functionality to be integrated into the sensor substrate 700 itself. As such, the output of the sensor substrate 700 can directly include the output of the distance sensors 701, eliminating the need for separate distance sensors. Such a distance sensor 701 integrated into the sensor substrate 770 avoids having separate distance sensors. Such separate distance sensors would be apart, for example spaced away, from the sensor substrate, other distance sensors, or both the sensor substrate and another distance sensor. Such a separate distance sensor is a separate member. As a separate member it is assembled into the apparatus or even charged particle device 41 separately. The precise relative position of a such a separate distance sensor with respect to another distance sensor or the sensor substrate is dependent on the positioning of the separate distance sensor at the moment of assembly. Therefore, there is a variation in the positioning between separate distance sensors with respect to another distance sensor and a sensor substrate in different implementations (e.g. charged particle devices or apparatuses). Such variation requires calibration during set up. Integrating one or more distance sensors into a sensor substrate, or multiple distance sensors into a common substrate reduces the calibration required as will be explained herein.

The sensor substrate 700 may further comprise at least one signal detector 710 configured to detect signal particles emitted from the sample 208. As further explained below, the signal detector 710 is a type of charged particle optical component and may be replaced or used in combination with a other types of charged particle optical component.

Due to the integration in the sensor substrate 700, a functional area of the sensor substrate 700 (e.g. comprising a charged particle detector 710 as described further below) is already aligned with the functional area of the distance sensor 701 in the same substrate. In other words, the charged particle detector 710 and the distance sensor 701 can be provided in the same mechanical housing. This reduces or eliminates any need to align and/or calibrate mechanical positioning of the charged particle detector 710 and the distance sensor 701 during production and/or operation.

The integration of the distance sensor 701 within the sensor substrate 700 allows for smaller base or facing surface, for example a smaller cross-sectional surface area, of charged particle device 41 (e.g. which may be referred to as a microscope head for an assessment device used as a microscope). A reduction in the base may contribute to future feasibility of a multi-device assessment apparatus, e.g. which may be referred to as a multicolumn microscope. In such a multi-device architecture multiple charged particle devices direct a plurality of charged particle beams to a sample in parallel and at the same time. Thus, multiple microscope heads may operate on one sample at the same time, increasing assessment throughput.

As the distance sensor 701 and signal detector 710 are provided as part of the sensor substrate 700, thermal expansion of the sensor substrate 700 may be the same. Consequently the thermal expansion generally varies consistently throughout the sensor substrate 700, desirably more consistently than in an arrangement with a distance sensor separate from a signal detector. This is beneficial in that the thermal expansion can be characterized over the thermal range for all of the distance sensors 710 and signal detectors 701 which may be part of the sensor substrate 700. This reduces the likelihood of some of the sensors moving relative to the other sensors, which may be more likely if the sensors and detectors were mounted separately in the assessment apparatus 40, for example to different members or housing.

The signal detector 710 may be a charge type detector, for example, as shown in **Figures 8** and **9****.** The charge type detector 710 may be formed of a metal layer on a surface of the sensor substrate 700.

Desirably at least one aperture 711 is defined through the sensor substrate 700 for the passage of at least one beam towards the sample 208 and/or sample position. During operation, the sensor substrate 700 may be positioned such that the aperture 711 is aligned along a primary beam path 320.

As shown in at least **Figures 8** and **9****,** the signal detector 710 may be associated with the aperture 711. The aperture may be defined in the substrate 700, desirably in the signal detector 710. The signal detector 710 may be positioned surrounding the aperture 711. The signal detector may comprise a detector surface that is desirably, substantially annular. The signal detector 710 may be provided as a single portion (e.g. as a single electrode). Alternatively, the signal detector 710, desirably the detector surface, may comprise multiple portions arranged around a single aperture 711, for example, as described above in relation to **Figures 5A** and **5B****.**

The sensor substrate 700 may be formed of any appropriate material. For example only, the sensor substrate may be formed of silicon. Thus a main body (i.e. structure) of the sensor substrate 700 may be silicon.

The distance sensors 701 are desirably positioned proximate to the signal detector 710. The distance sensors 701 may be positioned surrounding the signal detector 710. Thus, the distance sensors 701 may all be positioned radially outwards of the signal detector 710, i.e. further from the aperture 711 than the signal detector 710. Desirably, the plurality of distance sensors 701 are positioned equidistantly from an origin. For example, the distance sensors 701 may each be positioned the same distance away from a center of the aperture 711, which is desirably the position of the primary beam path 320 during operation. Desirably, adjacent distance sensors 701 are separated by similar distances, as shown in **Figure 8****.** In other words, the distance sensors 701 may be equally spaced from each other. Desirably, the distance sensors 701 are positioned around an edge of the sensor substrate 700, as shown in **Figure 8****,** i.e. towards an outer periphery of the sensor substrate 700. However, this is not a necessity and the distance sensors 701 may be positioned in any appropriate position or configuration. For example only, the distance sensors 701 may be interleaved with other members/components, one or more of the distance sensors desirably being located in non-beam areas between the other members or components in areas which may be referred to as 'beam areas' corresponding to paths of beams through the members or components. For example, as in at least one of figures 1 and 8A of US2012/0305798 or at least one of figures 21, 22 or 23 of EP A 20213733.7 filed on 14 December 2020, which discloses interleaved group locations of sub-beam processed areas and unfilled footprint portions (instead of non-beam and beam areas). The US2012/0305798 and the EP Application are hereby incorporated by reference at least so far as the disclosure of beam areas and non-beam areas (or equivalent features). For example, the distance sensors 701 may be interleaved with signal detectors 710, for example in a multi-device apparatus, which desirably enables one sensor substrate to be used for multiple devices (columns) enabling the devices to be positioned closer together with a smaller pitch. This may be beneficial in case the substrate 700 contains a large array of signal detectors 710 in a relatively large area as the interleaved distance sensors 701 may be used to measure the distance at points inside that array. Such a situation may be applied in a multi-column (or multi-charged particle device) arrangement.

As shown in **Figure 9****,** when the sensor substrate 700 is positioned for operation (e.g. so as to generate a measurement signal representative of a distance between the distance sensor 710 and a facing surface of a target), a sensing surface 721 of the distance sensor 701 (of which an example may be referred to as the main surface of the distance sensor 701) and a detecting surface 722 of the signal detector 710 (an example of which may be referred to as the main surface of the signal detector 710) may be configured to face the sample 208 (or any appropriate target). The sensor substrate 700 may be in operation when positioned in, and part of, a larger device 41 or apparatus 40. Desirably, the sensing surface 721 and/or the detecting surface 722 provide at least part of a base of the charged particle optical device 41. The sensing surface 721 of the distance sensor 701 and the detecting surface 722 of the signal detector 710 may be parallel to each other. Desirably, the sensing surface 721 of the distance sensor 701 and the detecting surface 722 of the signal detector 710 are in the same plane. Due to the alignment of the sensing surface 721 of the distance sensor 701 with the detecting surface 722 of the signal detector 710, the distance between the distance sensor 701 and the sample 208 can be smaller. As the distance noise increases with the square of the distance, providing a substrate which enables a smaller distance results in lower distance measurement noise. A lower distance measurement noise may be achieved when the proportion of noise to measurement signal in a distance measurement is lower (or smaller). In further detail, due to the integration of the distance sensor 701 and the signal detector 710 in the substrate, the total tolerance train can be reduced. In other words, these members can be positioned with greater precision. In turn, this means that it is possible to position the members closer to the target, i.e. the distance between the distance sensor 701 and the sample 208 can be smaller.

The sensing surface 721 of the distance sensor 701 may be at least a part of a main planar surface of the sensor substrate 700. In other words, the sensing surface 721 of the distance sensor 701 may form at least part of an outermost surface of the sensor substrate 700. Additionally, the sensing surface 721 of the distance sensor 701 may be a planar surface, i.e. flat. The sensing surfaces 721 of all of the distance sensors 701 may be in the same plane. As described above, the detecting surface 722 of the signal detector 710 may be in the same plane as the sensing surface 721 of the distance sensor 701. Thus, the detecting surface 722 of the signal detector 710 may also form part of a main planar surface of the sensor substrate 700.

The sensor substrate 700 may comprise circuitry (as herein shown and described in reference to **Figures 6A** to **7****).** Circuitry may be associated with the distance sensor 701 and/or the signal detector 710. Desirably, the sensor substrate 700 comprises circuitry configured to process a detection signal generated by the signal detector 710. Additionally or alternatively, the sensor substrate 700 comprises circuitry configured to process the measurement signal from the distance sensor 701. The circuitry (associated with either or both of the distance sensor 701 and/or the signal detector 710) may be positioned in any appropriate location. For example, the circuitry may be partly or wholly comprised in an insulating element 730 (which may be provided as an insulating layer) and/or the circuitry may be partly or wholly comprise comprised in a circuitry layer 720.

The sensor substrate 700 may comprise the isolating element 730. As will be clear from the below, the isolating element 730 may provide at least part of the distance sensor 701. Additionally or alternatively, the isolating element 730 may provide at least part of the signal detector 710. The isolating element 730 may be provided as multiple isolating portions, or as a single integral portion or member. The isolating element 730 may be provided as an isolating layer, as shown in **Figure 9****.** The isolating element 730 may be provided as an isolating film.

As shown in **Figure 9****,** the isolating element 730 may be part of the distance sensor 701, i.e. the distance sensor 701 desirably comprises at least part of the isolating element 730. At least part of the distance sensor 701 may be supported by the isolating element 730. Each distance sensor 701 may comprise a sensing electrode 704. The sensing electrode 704 may be supported by the isolating element 730. Thus, the sensing electrode 704 may be positioned on, and connected to the sensor substrate 700 by the isolating element 730. Other constituent features of the distance sensor 701 (e.g. other electrodes if provided) may also be supported by the isolating element 730. An arrangement in which the distance sensor 701 has at least another electrode may provide a differential distance sensor. In other words, the distance sensor 701 may be a differential sensor. A differential distance sensor has at least two electrodes for a distance measurement (i.e. at least two sensing electrodes). Thus, each distance sensor 701 may comprise two sensor elements, desirably configured to make a differential measurement with respect to each other. A distance measurement using a differential distance sensor is based on the signal generated by each of the two electrodes, as disclosed in US2011/0261344 which disclosure so far as differential sensors is incorporated by reference. Electrodes of the distance sensor 701, such as the sensing electrode 704 (which may provide the sensing surface 721), may be configured (during operation) to face the target, as shown in **Figure 9****.** In **Figure 9****,** the distance sensor 701 is shown to be positioned on a flat surface of the isolating element 730. It will be understood that the distance sensor 701 may be provided in a recess in the isolating element 730 such that a main surface of the isolating element and the sensing surface 721 of the distance sensor 701 can be provided in the same plane, i.e. are level. In other words, at least part of the isolating element 730 (or isolating features) or at least a grounded electrode, may be positioned between the distance sensors 701 and/or the signal detectors 710, and/or between constituent features of distance sensors 701 and/or the signal detectors 710.

Although **Figure 9** shows that an integral isolating element 730 is to be used throughout the sensor substrate 700, this is not necessary, and a portion of the isolating element may be associated with the distance sensor 701 which is separate from at least one other portion of the isolating element. Each distance sensor 701 may have its own portion of the isolating element. In this case, each distance sensor 701 desirably has its own portion of the isolating element in an isolating layer. Thus, the portions of the isolating element 730 associated with each of the distance sensors 701 are desirably provided in a plane. Desirably, each portion of the isolating element associated with one of the distance sensors 701 is corresponding in shape to a shape of that distance sensor 701. For example, if the distance sensor 701 is substantially square in plan (as in **Figure 8****),** the portion of the isolating element associated with that distance sensor 701 may also be substantially square and of a similar size in plan. The shape of the isolating element may be substantially concentric with that of the distance sensor 701.

Circuitry may provide at least part of the distance sensor 701. Additionally or alternatively, circuitry may provide at least part of the signal detector 710. At least part of a circuitry of the sensor substrate may be positioned in the isolating element 730.

Desirably, the circuitry in a portion of the isolating layer associated with the at least one distance sensor 701 is the circuitry of the at least one distance sensor 701. In other words, circuitry which is part of the distance sensor 701 may be positioned in the isolating element. Furthermore, if only a portion of the isolating element is associated with the distance sensor 701, this portion of the isolating element desirably comprises circuitry associated with the respective distance sensor 701. For example, **Figure 9** depicts vias 705 and 706 (i.e. electrical connectors) from the distance sensor 701 to the circuitry layer 720. Additional parts of the circuitry associated with the distance sensor 701 may be provided in the isolating element.

As shown in **Figure 9****,** the isolating element 730 may be part of the signal detector 710, i.e. the signal detector 710 desirably comprises at least part of the isolating element 730. At least part of the signal detector 710 may be supported by the isolating element 730. Each signal detector 710 may comprise a detecting electrode (e.g. the metal layer referred to above). The detecting electrode may be supported by the isolating element 730. Thus, the signal detector 710 may be positioned on, and connected to the sensor substrate 700 by the isolating element 730. Other constituent features of the signal detector 710 (e.g. other electrodes if provided) may also be supported by the isolating element 730. Detector electrodes of the signal detector 710 may be configured (during operation) to face the target, as shown in **Figure 9****.** In **Figure 9****,** the signal detector 710 is shown to be positioned on a flat surface of the isolating element 730. It will be understood that the signal detector 710 may be provided in a recess in the isolating element 730 such that a main surface of the isolating element and the detecting surface 722 of the signal detector 710 can be provided in the same plane, i.e. are level. In other words, at least part of the isolating element 730 (or isolating features) or at least a grounded electrode, may be positioned between the distance sensors 701 and/or the signal detectors 710, and/or between constituent features of distance sensors 701 and/or the signal detectors 710.

In the arrangement depicted in Figure 9, the detecting surface 722 of the signal detector 710 is in the same plane with respect to the sensing surface 721 of the sensor 701. However, this is not a necessity. Alternatively, in any of the embodiments or variations described herein, the sensing surface 721 may be further down-beam, for example closer to a sample position, than the detecting surface 722. Alternatively, in any of the embodiments or variations described herein, the sensing surface 721 may be at a position further up-beam, for example further away from a sample position, than the detecting surface 722. As described herein, at least respective portions the isolating surface 731 of the isolating element may be in the same or different planes as the detecting surface 722, the sensing surface 721, or both.

As shown in **Figure 9****,** the isolating element 730 may be common to both the distance sensor 701 and the signal detector 710. Thus, the same isolating element 730 may be used for the distance sensor 701 and the signal detector 710, i.e. an integral isolating element can be used for the sensor substrate 700.

Although **Figure 9** shows that an integral isolating element is to be used for the sensor substrate 700, this is not necessary, and a portion of the isolating element may be associated with the signal detector 710 which is separate from at least one other portion of the isolating element. Each signal detector 710 may have its own portion of the isolating element. In this case, each signal detector 710 desirably has its own portion of the isolating element in an isolating layer. Thus, the portions of the isolating element 730 associated with each respective signal detector 710 are desirably provided in a plane. The portions of the isolating element associated with the at least one signal detector 710 may be in the same plane as at least one, or all, portions of the isolating element associated with the at least distance sensors 701. Desirably, each portion of the isolating element associated with one of the signal detectors 710 is corresponding in shape to a shape of the signal detector 710. For example, if the signal detector 710 is substantially circular in plan (as in **Figure 8****),** the portion of the isolating element associated with that signal detector 710 may also be substantially circular and of a similar size in plan.

Desirably, the circuitry in a portion of the isolating layer associated with the at least one signal detector 710 is the circuitry of the at least one signal detector 710. In other words, circuitry which is part of the signal detector 710 may be positioned in the isolating element. If only a portion of the isolating element is associated with the signal detector 710, this portion of the isolating element desirably comprises the circuitry associated with the respective signal detector 710. For example, **Figure 9** depicts a via 707 (i.e. electrical connector) from the signal detector 710 to the circuitry layer 720. Additional parts of the circuitry associated with the signal detector 710 may be provided in the isolating element.

Although **Figure 9** shows that an integral circuitry layer 720 is to be used throughout the sensor substrate 700, this is not necessary. A portion of the circuitry may be associated with the distance sensor 701 which is separate from at least one other portion of the circuitry. A portion of the circuitry may be associated with the signal detector 710 which is separate from at least one other portion of the circuitry. Thus, the circuitry may be provided as multiple circuitry portions, or as a single integral portion or member. Either way, the circuitry may be comprised in the circuitry layer 720 of the sensor substrate. Desirably the circuitry in a portion of the circuitry layer 720 associated with the each distance sensor 701 and/or signal detector 710 is the circuitry of each distance sensor 701 and/or signal detector 710 respectively. Desirably, each portion of the circuitry layer associated with one of the distance sensors 701 is corresponding in shape to a shape of the distance sensor 701. For example, if the distance sensor 701 is substantially square in plan (as in **Figure 8****),** the portion of the circuitry layer associated with that distance sensor 701 may also be substantially square and of a similar size in plan. Desirably, each portion of the circuitry layer associated with one of the signal detectors 710 is similar, or even corresponding, in shape to a shape of the signal detector 710. For example, if the signal detector 710 is substantially circular in plan (as in **Figure 8****),** the portion of the circuitry layer associated with that signal detector 710 may also be substantially circular and of a similar size in plan. The portion of circuitry, such as a portion of a circuitry layer for example within the sensor substrate, that is associated with a feature of the sensor substrate 700, may confirm to the same shape and size to the shape of the feature in a plane of the sensor substrate 700.

Although the figures show the circuitry layer 720 as part of the sensor substrate 700, additionally or alternatively, at least one circuitry layer may be present in an associated substrate, for example, for processing the detection signal. Such an associated substrate may be arranged as per the circuitry layers as in the sensor substrate. The associated substrate may be secured to the sensor substrate 700, for example, with solder balls. Such a further substrate may be used in known detector architecture and can be applied to the embodiments and variations described herein in addition or as an alternative to the circuitry layer 720.

Desirably, the circuitry in the circuitry layer 720 is connected to the distance sensor 701 and/or signal detector 710 through at least a portion of the isolating element. The circuitry layer may be electrically connected to all the distance sensors 701 and signal detectors 710 provided. Such connections between layers may be vias (such as through silicon vias) extending through one more layers of the sensor substrate.

The distance sensors 701 may be capacitive sensors. Generally, capacitive sensors can be used by detecting changes in capacitance between the sensing electrode 704 and the target as the distance between the sensing electrode 704 and the target changes. This is described in detail in US 2011/0261344 which is hereby incorporated by reference herein. For example only, the distance sensors 701 may be differential distance sensors as described above, and may be provided with at least two sensing electrodes to provide such capacitive sensors.

Capacitive sensors are beneficial in being capable of providing measurements of the distance to a target, for example between two proximate surfaces, with sufficient accuracy. Each capacitive sensor may comprise a sensing electrode 704, which is a conductive sensing electrode. The capacitance is proportional to the area of the sensing surface and inversely proportional to the distance between the sensing surface and the target. If the distance to the target is smaller, the area of the sensing surface can be smaller as well, while still having the same capacitance. For example only, an area of the main surface (i.e.an example of a sensing surface) of the sensing electrode may be any appropriate size. The area may be at least a few mm², e.g. at least approximately 1mm², at least approximately 5 mm², or at least approximately 10 mm² or more. The area may be smaller than 5 mm², or may be greater, for example the area may be tens of mm², or at least 1 cm², or a few cm², or tens of cm². The area may be approximately 5 mm² to 100 mm², or preferably 10 mm² to 50 mm². Generally, the capacitance is linearly related to the area of the electrode, and so providing a sensing electrode of such a size provides enough capacitance to accurately measure the distance for example between the electrode and facing surface of the stage such as the sample. The sensing electrode is shown as square in **Figures 8** and **9****,** but may be provided in any shape.

Desirably each capacitive sensor comprises a guard electrode 703, which is a conductive guard electrode. The guard electrode 703 may be provided to the side of the sensing electrode 703 in cross section as. The guard electrode 703 may desirably surround the sensing electrode 704 in plan as shown in **Figure 8****.** The sensing electrode 704 and the guard electrode 703 may be positioned on at least part of the isolating element 730 (as described above). There may be a gap between the sensing electrode 704 and the guard electrode 703, i.e. the sensing electrode 704 and the guard electrode 703 are not touching. The gap is desirably narrow, and may be an air gap or may comprise at least part of the insulating element 730. The guard electrode 703 may be set at the same potential as the sensing electrode 704 that it surrounds.

Without the guard electrode, the electric field between the sensing electrode 704 and the target may bend at or near the edge of the sensing electrode. The sensing electrode 704 may be susceptible to parasitic capacitances. If there is a conductor near the edge of the sensing electrode 704, this can affect the electric field which can affect the measurement signal generated by the distance sensor 701. These issues can be reduced or avoided due to the provision of the guard electrode 703 surrounding the sensing electrode 704 with the guard electrode 703 being provided with the same potential as the sensing electrode 704. The guard electrode 703 may improve predictability of the distance measurement and make it easier to model the measurement signal. Thus, the guard electrode 703 can function as a shield against external interference. The guard electrode 703 may be beneficial in reducing or avoiding the effects of electric field bending in an area between the sensing electrode 704 and the target which can reduce, or even avoid, parasitic capacitance.

Optionally, each capacitive sensor may comprise a back guard electrode (not shown) . The back guard electrode may be positioned on the isolating element, preferably a back side (or up-beam surface) of the insulating element 730, i.e. a side of the isolating element 730 opposite to the isolating surface 731 on which the sensing electrode 704 is positioned. The back guard electrode may be provided as a layer. The back guard electrode may substantially correspond in shape to the isolating element 730, or may be provided to correspond to the shape (e.g. the outer perimeter) of the distance sensor 701 (or the sensing electrodes 704 and/or the guard electrodes 703 of one distance sensor 701). The back guard electrode may be beneficial in preventing the operation of the capacitive sensor from being influenced by currents behind the capacitive sensor and the sensor unduly influencing control of the beams. An example of a back guard electrode is shown in figure 5 of US 2011/0261344, which is hereby incorporated by reference at least by reference to the disclosure of a back guard electrode.

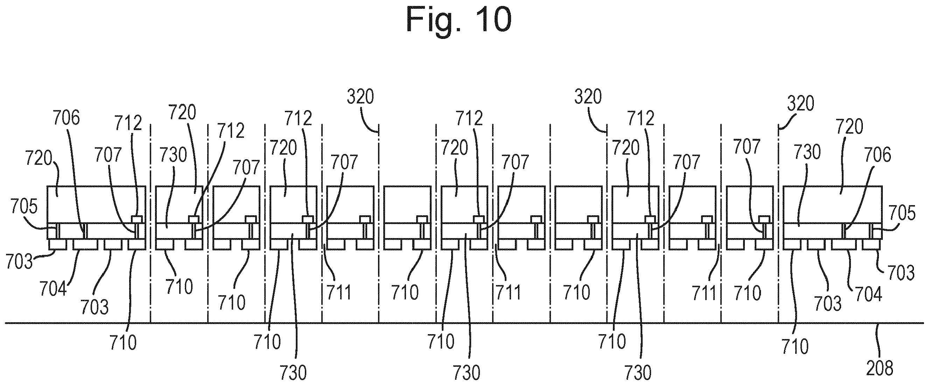

**Figures 8** and **9** show a sensor substrate 700 with a single aperture 711. Such a sensor substrate 700 can be used for a single primary charged particle beam. It may be preferable for the sensor substrate 700 to be suitable for use with multiple primary charged particle beams. Although theoretically multiple primary charged particle beams may be passed through a single aperture, such as the aperture 711 as shown in **Figures 8** and **9****,** other configurations are also possible. For example, the aperture 711 may be provided as a slit or an array of slits, rather than a through hole. Such a slit may have multiple primary charged particle beams pass through it to the sample 208. Alternatively, the sensor substrate 700 may define an array of apertures 711. Each of the apertures in the array may be provided for the path of at least one beam primary charged particle beam (or sub-beam) towards the target position. As shown in **Figure 10****,** each aperture 711 may correspond to a single primary charged particle beam and/or primary charged particle beam path 320. The sensor substrate 700 may comprise an array of signal detectors 710. For example, the sensor substrate 700 may comprise at least one signal detector 710 associated with each of the apertures 711. Desirably at least one signal detector 710 is positioned surrounding at least one of the apertures 711. Thus, each aperture 711 may have a single corresponding signal detector 710 around it, as shown in **Figure 10****.** (Note for efficient the features associated with some but not all of the detectors 710 and apertures 711 are labeled with references). The signal detectors 710 may be arranged in a two-dimensional array. The two-dimensional array may be a hexagonal close packed array as described above in relation to **Figure 4****,** or may be differently arranged, e.g. in a rectangular array. As described above, the signal detector 710 may be provided as a single portion (e.g. as a single electrode). Alternatively, the signal detector 710 may comprise multiple portions arranged around a single aperture 711, for example, as described above in relation to **Figures 5A** and **5B****.**

As shown in **Figure 10****,** the electrodes of the signal distance sensor 701 may be connected to the circuitry layer 720 by vias 705 and 706, as described above. In particular, at least one via 705 may be provided to connect the guard electrode 703 (if provided) to the circuitry layer. At least one via 706 may be provided to connect the sensing electrode 704 to the circuitry layer 720. At least one signal detector 710 may have corresponding detector circuitry 712 as shown in **Figure 10****.** The detector circuitry 712 may be separate from circuitry in other parts of the circuitry layer 720 as shown in **Figure 10****,** however, this is not a necessity and the circuitry for the signal detector 710 could be integral with the other circuitry components in the circuitry layer 720. The signal detector 710 may be connected to the circuitry layer 720 (or more specifically the detector circuitry 712 if provided as a discrete portion of the circuitry) by via 707.

The sensor substrate 700 may be the same as substrate 404 described above, with the addition of the distance sensors 701 described herein. In this case, the signal detectors 710 may correspond to the detector electrodes 405 and may be provided in any appropriate arrangement.

The embodiments above generally include four distance sensors 701 which are substantially equally spaced from each other and at approximately the same radial distance from a center of the sensor substrate 700. However, it is not necessary to provide four distance sensors 701 which are approximately at the same radial distance. Instead at least one distance sensor 701 may be at a different radial distance from the center compared to at least one of the other distance sensors 701. The distance sensors 701 may all be provided at different radial distances from the center of the sensor substrate 700.

Additional or alternative distance sensors may be provided. For example, additional distance sensors may be provided which are desirably positioned radially outwards of the distance sensors described above. For example, additional distance sensors may be provided which are desirably positioned radially inwards of the distance sensors described above. These additional distance sensors may or may not be integral with the sensor substrate 700.

Although the above describes the sensor substrate 700 with four distance sensors 701, any appropriate number of distance sensors 701 may be provided. In an arrangement, for example, there may be eight distance sensors 701 of two groups, all of the distance sensors desirably being proximate the charged particle component being radially inward of the distance sensors. A distance sensor of a first group may be positioned equidistantly away from each other, for example, providing the corners of a rectangle or even a square. Each of the four remaining sensors of the second group may be placed between, for example directly between two sensors of the first group. A sensor of the second group may be positioned equidistantly between the adjoining sensors from the first group. In another embodiment, for example, the sensor substrate 700 may be provided with only one, i.e. a single, distance sensor. Thus, the figures described above may be adapted to have one distance sensor only. Although the sensor substrate 700 can still function using a single distance sensor 700, it is preferable to have a plurality of distance sensors to improve accuracy of the measurement of the distance to the target and for alignment of the surface of the sensor substrate relative to the target. For example, comprising at least 3 distance sensor is beneficial in that the sensors can be used to ensure alignment of the sensor substrate 700 relative to the target. For example, it may be beneficial to have four (4) distance sensors because it ensure that a sample faces at least one distance sensor during operation of the charged particle device 41. Further, using multiple distances sensors provide additional information relating to the distance to the target and may be used for more accurate positioning such as tilt, or rotation about axes within a plane orthogonal to the direction of the beam path; that is two additional degrees of freedom. More than four distance sensors may also be provided. For example any number between five and twenty or more distance sensors may be provided for example 5, 6, 7, 8, 9, 10, 11, 12, 13, 14, 15, 16, 17, 18, 19, 20 or more distance sensors may be provided as may be required. It is noted that distance sensor may be a differential sensor. Each distance sensor of the differential sensor may be considered a separate, different distance sensor being a separate capacitive sensor ; alternatively a distance sensor may comprise a differential sensor comprising two consistent capacitive sensors.

Although the above describes that the distance sensor 701 is a capacitive sensor, the at least one distance sensor 701 may additionally or alternatively be any appropriate type of sensor. For example, the distance sensor 701 may be an inductive sensor. The inductive sensor may use an electro-magnetic field to generate the measurement signal representative of the distance between the inductive sensor and the target. The inductive sensor may comprise one or more current loops (or a coil), for example within the substrate, which is excited by an AC current. The voltage over the current loop is proportional to the inductance of the loop. This inductance is influenced by a magnet such as of ferromagnetic material in or nearby the loop. By moving the magnet relative to the loop, the inductance may vary. For example by moving a ferromagnetic material away from the loop, the inductance will get smaller. By doing so, the distance can be derived; for example at least changes in a detected voltage signal may be used to derived a change in distance.

Although the above describes that the signal detector 710 is a charge type detector, the at least one signal detector 710 may additionally or alternatively be any appropriate type of detector. For example, the signal detector 710 may comprise a semiconductor type detector element, such as a PIN detector element, and/or a scintillating type detector element.

The signal detector 710 described above is one type of charged particle optical components which may be part of the sensor substrate 700. However, different types of charged particle optical component may be provided instead or in addition to the signal detector 710.

It is described above that the detecting surface 722 may be a main surface of the signal detector. If a different type of charged particle optical component is provided, the main surface of the charged particle component may be any appropriate surface used for a specific function of the charged particle optical component. The main surface need not be largest surface of the charged particle optical component, although it could be.

For example, the charged particle optical component may additionally or alternatively comprise a lens electrode configured to lens (i.e. to converge or diverge) at least one charged particle beam. The charged particle optical component may comprise a macro-electrostatic lens, which may desirably be provided around an aperture as part of a single beam system or may be provided around multiple apertures for a multi-beam system. In this case, the substrate 700 may be provided without the isolating element 730 (for example compared to **Figure 9****),** and a potential may be applied to the substrate 700 to function as an electrode. For example, the charged particle optical component may be part of an objective lens (or objective lens array 241 as described above). In this case, the charged particle optical component may provide the down beam most electrode of the objective lens (or objective lens array 241). The distance measured by the distance sensor may be the distance between the sensor substrate and the sample 208 (indicative of the distance between the lens and the sample). Alternatively, the charged particle component may be part of a control lens (or control lens array 250). In this case, the charged particle optical component may provide the down beam most electrode of the control lens (or control lens array 250). The distance measured by the distance sensor may be the distance between the sensor substrate and a down-beam member which is the target (indicative of the distance between the lens and the target).

Additionally or alternatively, the charged particle optical component may comprise a lens plate when part of a multi-beam system. Desirably the lens plate defines an array of apertures wherein each aperture can be aligned along one of the charged particle beam paths. Such a lens plate may be made from the silicon of the CMOS device. Desirably, the detector array is located up-beam of the most down beam electrode of the objective lens arrangement (which may include the objective lens and desirably the control lens electrodes). A signal detector 710 may be positioned up beam of the detector substrate 700 for example on, or integrated into, a member of the objective lens arrangement or even up-beam of the objective lens arrangement.

Additionally or alternatively, the charged particle optical component may comprise a deflector electrode configured to deflect at least one charged particle beam. The charged particle optical component may comprise a plurality of deflector electrodes, with at least one deflector electrode being provided for each aperture. Desirably the electrodes of the different apertures are controllable separately. There may be a plurality of deflector electrodes for each at least one charged particle beam, such that the charged particle optical component may be provided as a multipole deflector or an array or multipole deflectors. An example of a multipole is described in US 2012/0305798, for example in relation to at least figures 2 and 6, which is hereby incorporated by reference. Desirably the plurality of electrodes are arranged around each at least one aperture defined in the sensor substrate 700. In other words, there can be multiple electrodes associated with a single charged particle beam through an aperture. The plurality of electrodes for each at least one aperture may be individually controllable. In an arrangement a signal detector 710 or even sensor array 241 is located down beam of the sensor substrate 700, desirably the sensor substrate 700 comprising one more distance sensors 701 and multiple electrodes surrounding an aperture for the path of one more beams; in such an arrangement the sensor substrate may be more remote from the sample position than the signal detector 710.

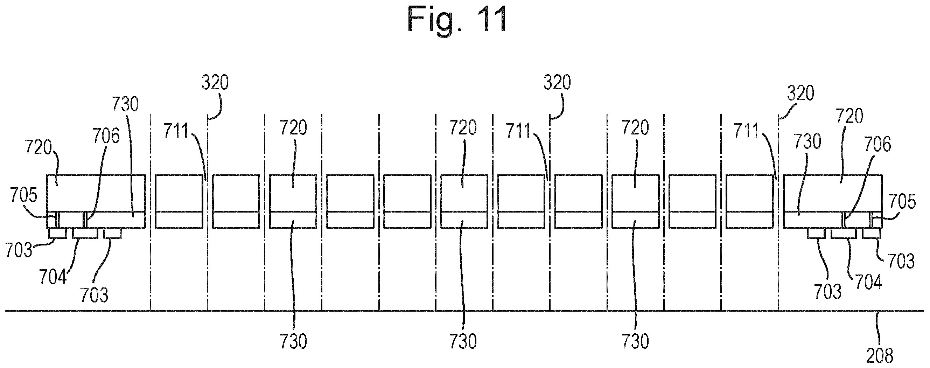

Although the above describes a substrate with at least one charged particle optical component, the sensor substrate may be provided with a plurality of distance sensors without a charged particle optical component, i.e. without the charge type detector shown in **Figures 8** to **10****.** Even when no charged particle component is provided, there are still advantages in that the plurality of distance sensors are directly aligned with each other and do not need calibration, for example, during operation. In particular, the sensor substrate 700 is desirably suitable for a multi-beam charged particle assessment apparatus. Desirably, the sensor substrate 700 comprises the plurality of apertures 711 as described above in relation to **Figure 10****.** An example of such an embodiment is depicted in **Figure 11****,** which comprises the sensor substrate 700 with the distance sensors 701 as described above, but without any signal detectors. It will be understood that any of the adaptations and variations described herein relating to the sensor substrate 700 and/or distance sensors above may be apply to such an embodiment without the signal detector 710/charged particle optical component.

In the figures described above, the sensor substrate 700 is shown as square with square distance sensors 701 and a circular charged particle component (signal detector 710). The sensor substrate 700, distance sensor(s) 701 and/or charge particle optical component can each be provided with any appropriate shape in any appropriate combination. For example, the sensor substrate, distance sensor(s) and/or charge particle optical component may be substantially the same shape or may all be different shapes. At least two of the sensor substrate, distance sensor(s) and/or charge particle optical component may be the same shape. Any appropriate shape includes, but is not limited to, a square, hexagon, rectangle, circle, oval, triangle, polygon, semi-circle, etc..

In an embodiment, a charged particle device 41 is provided. The charged particle device 41 is desirably configured to project a multi-beam of charged particles towards the sample position. The charged particle device 41 comprises the sensor substrate 700 in any of the embodiments or variations described above. The charged particle device 41 may comprise multiple sensor substrates 700 which may be positioned in different locations of the apparatus. In this case, the charged particle optical component may be provided in different forms. For example, a sensor substrate 700 may be provided with at least one signal detector 710 and may desirably be positioned proximate the sample 208. A further sensor substrate may be provided with at least one control lens electrode and may desirably be positioned up-beam of the other sensor substrate. Additionally, the charged particle device may further comprise a plurality of charged particle components up beam of the sensor substrate 700 that are positioned along paths of a plurality of charged particle beams of the multibeam towards a sample position, the plurality of charged particle components configured to operate on the plurality of beams of the multi-beam. The plurality of charged particle components could be any type of charged particle component, e.g. as described above.

In an embodiment, a charged particle assessment apparatus for assessing the sample 208 is provided. The charged particle assessment apparatus is desirably configured to project a beam of charged particles towards the sample position. The charged particle assessment apparatus comprises the sensor substrate 700 in any of the embodiments or variations described above. The charged particle assessment apparatus may comprise multiple sensor substrates 700 which may be positioned in different locations of the apparatus. In this case, the charged particle optical component may be provided in different forms. For example, a sensor substrate 700 may be provided with at least one signal detector 710 and may desirably be positioned proximate the sample 208. A further sensor substrate may be provided with at least one control lens electrode and may desirably be positioned up-beam of the other sensor substrate.

The charged particle optical device and/or the charged particle assessment apparatus may further comprise a sample support (e.g. sample holder 207) configured to support the sample 208. As described above, the sample support may be supported by a actuated stage 209. Desirably a facing surface of the target is a surface of the sample 208 and/or sample support.

The charged particle assessment apparatus may further comprise a sample controller (e.g. controller 50) configured to control the position of the sample 208 and/or the sample holder based on the measurement signal from the distance sensor 701. The sample controller may be in electrical communication with the circuitry relating to the distance sensor 701. The controller and/or the distance sensor circuitry may process the measurement signal to determine the distance from the distance sensor 701 to the sample and/or to determine if a change in the distance from the distance sensor 701 to the sample is required. The controller 50 may control the actuated stage 209, or any appropriate actuation mechanism, to move sample 208 depending on the measurement signal. The controller 50 may enable the actuated stage 209 to move the sample 208 in a direction up-beam and or down-beam depending on the measurement signal in order to adjust the distance between the sample 208 and/or sample holder and the sensor substrate 700. If the target is other than the sample 208, e.g. a member, feature or component of the device or apparatus or a product or item which is not part of the device or apparatus etc., any appropriate holder may be provided with an actuation mechanism configured to move the target and/or target holder depending on the measurement signal.

The charged particle optical device and/or the charged particle assessment apparatus may further comprise a sensor controller (e.g. controller 50) configured to control the position of the sensor substrate 700 based on the measurement signal from the distance sensor. The sensor controller may be in electrical communication with, or may be part of, the circuitry relating to the distance sensor 701. The sensor controller and/or the circuitry may process the measurement signal to determine the distance from the distance sensor 701 to the sample and/or to determine if a change in the distance from the distance sensor 701 to the sample is required. The controller 50 may control any appropriate actuation mechanism, to move the sensor substrate 700 depending on the measurement signal. The sensor controller may enable the actuation mechanism to move the sensor substrate in a direction up-beam and or down-beam depending on the measurement signal in order to adjust the distance between the target and the sensor substrate 700.

The position of the sample 208, sample support and/or sensor substrate 700 may be controlled to maintain a distance between the sensor substrate 700 and the sample 208 and/or sample support. Thus, the measurement signal may be used to determine if there is any change in the distance between the sensor substrate 700 and the sample 208 and/or sample support, and the appropriate adjustments can be made to move the sensor substrate 700 and/or the sample support for example.

In the charged particle assessment apparatus, the sensor substrate 700 may be positioned proximate to the sample 208 and/or sample support. In the charged particle assessment apparatus, the sensor substrate 700 may be positioned facing the sample 208 and/or sample support. This may be particularly useful in multi-beam systems which may have a large field of view (e.g. approximately 5 to 20 mm per device) with a preferred tight focus (e.g. approximately 10 to 500 nm) and tilt requirements because beams do not have active focus or have limited independent focusing. The distance between the device 41 and the sample may be small (e.g. approximately up to 250 micron for example 30 to 100 micron), and the sample height may vary by up to approximately 50 micron for example 30 micron. Thus, it may be particularly beneficial to accurately position the sensor substrate 700 relative to the sample 208 given the variation in the topography of the sample 208.

Desirably, the charged particle assessment apparatus comprises the charged particle device in any of the above embodiments or variations, i.e. comprising the sensor substrate. Desirably, the charged particle assessment apparatus comprises the source configured to emit a charged particle beam.

The present invention may also provide a method of generating a measurement signal representative of a distance between a distance sensor 701 and a facing surface of a target using a sensor substrate 700 or charged particle assessment apparatus as in any of the variations or embodiments described above.

A method is provided of generating a measurement signal representative of a distance between a distance sensor 701 to a facing surface of a target using a sensor substrate 700 comprising at least one distance sensor 701 and at least one charged particle optical component, the method comprising a); positioning the sensor substrate 700 so that the distance sensor 701 faces a facing surface of the target; b) generating, using the distance sensor 701, a measurement signal representative of the distance between the distance sensor 701 and the facing surface of a target. The method may include providing the sensor substrate 700 comprising at least one distance sensor 701 and at least one charged particle optical component, which may include swapping modules comprising at least the sensor substrate 700 within an apparatus or charged particle device.

A method is provided of generating a measurement signal representative of a distance between a distance sensor 701 to a facing surface of a target using a sensor substrate 700 comprising a plurality of distance sensors 701, the method comprising a) positioning the sensor substrate 700 so that the distance sensor 701 faces a facing surface of the target; b) generating, using the distance sensor 701, a measurement signal representative of the distance between the distance sensor 701 and the facing surface of a target.

These methods may further comprise positioning the sample 208 and/or a sample holder and/or the sensor substrate 700 based on the measurement signal from the distance sensor 701. Desirably, the positioning comprises using a controller to control the positioning. The positioning may comprise scanning the position of the sample 208 and/or the sample holder and/or the sensor substrate 700 relative to a primary charged particle beam directed at the at sample 208.

These methods may further comprising detecting signal particles. For example, the at least one charged particle optical component may be at least one signal detector 710, wherein detecting signal particles comprises using the at least one signal detector 710.

The invention provides a method of projecting a beam of charged particles onto a sample 208 so as to detect signal particles emitted from the sample 208 using a sensor substrate 700 comprising at least one distance sensor 701 and at least one signal detector 710, the method comprising a) positioning the sensor substrate 700 so that the distance sensor 701 faces a facing surface of the sample; b) generating, using the distance sensor 701, a measurement signal representative of the distance between the distance sensor 701 and the facing surface of the sample 208; c) controlling the position of the sensor substrate 700 and/or the sample 208 and/or a sample holder based on the measurement signal; d) projecting a charged particle beam along a primary beam path 320 onto a surface of the sample 208; and e) detecting signal particles emitted from the sample 208 at the at least one signal detector 710. Desirably, the beam used for this method is a multi-beam on impact with the sample 208. Thus, the multi-beam may comprise a plurality of sub-beams. Desirably the detecting of signal particles comprises detecting signal particles derived from different sub-beams impacting the sample 208 using a plurality of signal detectors 710. For example, each signal detector 710 may be used to detect signal particles predominantly, or completely, derived from a single one of the sub-beams.

The sample controller and/or the sensor controller may be part of a larger controller. For example, the sample controller and/or the sensor controller may be connected to, or in signal communication with controller 50. Thus, the sample controller and/or the sensor controller may be part of a generic controller, such as controller 50, and need not be a controller assigned specifically to the sample or sensor substrate respectively. The sample controller and/or the sensor controller may have members with which they are in signal communication which are outside of the sample, or sensor substrate 700, or device 41 or apparatus. Signal communication may be made wirelessly, or via a wired (i.e. cabled) connection. Thus, for example, only a part of the sensor controller may be included in the sensor substrate 700. The sensor controller and/or the sample controller may have sub-controllers. The sample controller and/or the sensor controller may be provided separate from controller 50.

In the present description, it will be understood that the charged particles/signal particles are generally intended to be electrons, or other negatively charged particles. However, contrary to the above, the charged particles/signal particles may be positively charged particles, e.g. ions. Thus, a primary ion beam may be provided. With a primary ion beam, secondary ions may be emitted from the sample that may be detected by the charge based type detector. However, this would also generate negative charged particles, e.g. secondary electrons at the same time. So the charge accumulated with this charge based type detector will be a mix of positively and negatively charged particles, which would make the charged measurement unreliable. However, having either a positive or negative bias on the charge based type detector would make it possible to choose one of the charge polarities. Because of the much smaller range of ions than electrons in a material, backscatter ions need a much larger kinetic energy to be able to reach any further detectors, e.g. the scintillator and/or semiconductor type detector. Thus, not all backscatter charged particles (or ions) will make it to this detector element. To improve the detection of backscatter ions, the charge based type detector may be made thinner. In the instance that ions are used instead of negatively charged particles, then any bias referred to above would be opposite, e.g. a positive bias should be used instead of a negative one and vice versa.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons. The charged-particle optical device may be configured to direct particles of negative charge towards a sample position. The charged-particle optical device may otherwise be referred to as an electron-optical device. It will be understood that an electron is a specific charged particle and can replace all instances of charged particle referred to throughout the application as appropriate. For example, the source may specifically provide electrons. The charged particle referred to throughout the specification may be specifically a negatively charged particle.

The charged particle-optical device or assessment apparatus may more specifically be defined as a charged particle-optical column. In other words, the device or apparatus may be provided as a column. The column may comprise a sensor substrate and optionally an objective lens array and/or a condenser lens array.

The charged particle assessment apparatus may comprise the objective lens array 240. The charged particle assessment apparatus may comprise the detector array 241 and/or detector assembly. The charged particle assessment apparatus may comprise the control lens array 250. The charged particle assessment apparatus comprising the objective lens array and the detector array may thus be interchangeable with, and referred to as, the objective lens array assembly, which may optionally comprise the control lens array 250. The charged particle assessment apparatus may comprise additional members, e.g. as described in relation to **Figure 3****.** Thus, the charged particle assessment apparatus may be interchangeable with, and referred to as, a charged particle assessment tool 40 and/or an charged particle optical system if comprising the additional members in these figures. The charged particle assessment apparatus may be referred to as, or at least comprising. a charged particle optical device.

An assessment tool according to an embodiment of the invention may be a tool which makes a qualitative assessment of a sample (e.g. pass/fail), one which makes a quantitative measurement (e.g. the size of a feature) of a sample or one which generates an image of map of a sample. Thus, the assessment tool may be any appropriate device, apparatus or system used for assessment. For example, the assessment tool may be any of the charged particle-optical device, e.g. as part of charged particle beam apparatus 100, or more specifically the charged particle-optical device 41, and/or as part of an optical lens array assembly, when used for assessment. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The charged particle beam tool 40 (which may be a charged particle -optical column) may be part of an assessment tool; such as an inspection tool or a metro-inspection tool, or part of an e-beam lithography tool. Any reference to a tool herein is intended to encompass a device, apparatus or system, the tool comprising various members which may or may not be collocated, and which may even be located in separate rooms, especially for example for data processing elements.

References to up and low, upper and lower, lowest, up and down, above and below should be understood as referring to directions parallel to the (typically but not always vertical) upbeam and downbeam directions of the electron beam or multi-beam impinging on the sample 208. Thus, references to up beam and down beam are intended to refer to directions in respect of the beam path independently of any present gravitational field.

References to elements being aligned along a beam path or sub-beam path are understood to mean that the respective elements are positioned along the beam path or sub-beam path.

Reference to a member or system of members (such as charged particle components) or elements being controllable to manipulate a charged particle beam in a certain manner includes configuring a controller or control system or control unit to control the member to manipulate the charged particle beam in the manner described, as well as optionally using other controllers or devices (e.g. voltage supplies and/or current supplies) to control the member to manipulate the charged particle beam in this manner. For example, a voltage supply may be electrically connected to one or more components to apply potentials to the member, such as in a non-limited list including the control lens array 250, the objective lens array 241, the condenser lens 231, correctors, collimator element array 271 and scan deflector array 260, under the control of the controller or control system or control unit. An actuatable member, such as a stage, may be controllable to actuate and thus move relative to another components such as the beam path using one or more controllers, control systems, or control units to control the actuation of the member.

The embodiments herein described comprising a detector assembly may take the form of a series of aperture arrays or charged particle-optical elements arranged in arrays along a beam or a multi-beam path. Such charged particle-optical elements may be electrostatic. In an embodiment all the charged particle-optical elements, for example from a beam limiting aperture array to a last charged particle-optical element in a sub-beam path before a sample, may be electrostatic and/or may be in the form of an aperture array or a plate array. In some arrangements one or more of the charged particle-optical elements are manufactured as a microelectromechanical system (MEMS) (i.e. using MEMS manufacturing techniques).

The device 41 (and/or any system or apparatus comprising the device 41) of such architectures as depicted in at least **Figure 3** and as described above may comprise members such as an upper beam limiter, a collimator element array 271, a control lens array 250, a scan deflector array 260, an objective lens array 241, a beam shaping limiter and/or a detector array 241 and/or detector assembly; one or more of these elements that are present may be connected to one more adjacent elements with an isolating element such as a ceramic or glass spacer.

Any element or collection of elements may be replaceable or field replaceable within the charged particle beam tool 40. The one or more charged particle-optical members in the charged particle beam tool 40, especially those that operate on sub-beams or generate sub-beams, such as aperture arrays and manipulator arrays may comprise one or more MEMS.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:
Clause 1. A sensor substrate for a charged particle optical device and/or a charged particle assessment apparatus, the sensor substrate comprising: at least one distance sensor configured to generate a measurement signal representative of a distance between the distance sensor and a facing surface of a target; and at least one charged particle optical component.
Clause 2. The sensor substrate of clause 1, comprising a plurality of distance sensors,
Clause 3. A sensor substrate for a multi-beam charged particle optical device and/or a charged particle assessment apparatus, the sensor substrate comprising a plurality of distance sensors configured to generate a measurement signal representative of a distance between the distance sensor and a facing surface of a target.
Clause 4. The sensor substrate of clause 3, further comprising at least one charged particle optical component.
Clause 5. The sensor substrate of any one of clauses 2 to 4, wherein the substrate comprises at least 3 distance sensors, desirably at least 4 distance sensors, desirably more than 4 distance sensors.
Clause 6. The sensor substrate of any one of clauses 2, 4 or 5, wherein the plurality of distance sensors are positioned surrounding the at least one charged particle optical component, desirably wherein the plurality of distance sensors are positioned equidistantly from an origin and/or adjacent distance sensors being separated by similar distances.
Clause 7. The sensor substrate of any one of the preceding clauses, wherein the distance sensor is proximate to the at least one charged particle optical component.
Clause 8. The sensor substrate of any one of the preceding clauses, wherein a sensing surface (e.g. a main surface) of the distance sensor and a main surface of the charged particle optical component are configured, when in operation, to face a target, desirably the main surface of the charged optical component is a base of a charged particle optical device.
Clause 9. The sensor substrate of clause 8, wherein the sensing surface of the distance sensor and the main surface of the charged particle optical component are parallel to each other.
Clause 10. The sensor substrate of either of clauses 8 or 9, wherein the sensing surface of the distance sensor and the main surface of the charged particle optical component are in the same plane.
Clause 11. The sensor substrate of any one of the preceding clauses, wherein the sensing surface of the distance sensor is in a main planar surface of the sensor substrate.
Clause 12. The sensor substrate of any one of the preceding clauses, wherein the distance sensor comprises at least part of an isolating element, desirably the or each distance sensor comprising a sensing electrode, desirably the sensing electrode configured to be supported by the isolating element.
Clause 13. The sensor substrate of clause 12, wherein at least part of a circuitry of the sensor substrate is positioned in the isolating element, desirably the circuitry in a portion of the isolating layer associated with the at least one distance sensor is the circuitry of the at least one distance sensor, desirably each portion corresponding in shape to a shape of the distance sensor.
Clause 14. The sensor substrate of any one of the preceding clauses, wherein the charged particle optical component comprises at least part of an isolating element, desirably the or each charged particle element comprising one or more detector electrodes, desirably the or each detector electrode is configured to face, when in operation, the target, desirably the or each optical electrode configured to be supported by the isolating element.
Clause 15. The sensor substrate of clause 14, wherein at least part of a circuitry of the sensor substrate is positioned in the isolating element, desirably the circuitry in a portion of the isolating layer associated with the at least one charged particle optical component, is the circuitry of the at least one charged particle optical component, desirably each portion corresponding in shape to a shape of the charged particle optical component.
Clause 16. The sensor substrate of any one of the preceding clauses, further comprising a circuitry layer comprising circuitry which is electrically connected to the distance sensor and/or charged particle optical component through an isolating element, desirably the circuitry in a portion of the circuitry layer associated with the at least one distance sensor and/or charged particle element is the circuitry of the distance sensor and/or the charged particle optical component, desirably each portion corresponding in shape to a shape of the connected distance sensor and/or charged particle optical component.
Clause 17. The sensor substrate of any one of the preceding clauses, wherein the distance sensor is a capacitive sensor.
Clause 18. The sensor substrate of clause 17, wherein the capacitive sensor comprises a sensing electrode and desirably a guard electrode, desirably wherein the guard electrode surrounds the sensing electrode.
Clause 19. The sensor substrate of any one of clauses 1 to 16, wherein the distance sensor is an inductive sensor.
Clause 20. The sensor substrate of any preceding clause, wherein the distance sensor is a differential sensor, desirably each distance sensor comprising two sensor elements desirably configured to make a differential measurement with respect to each other.
Clause 21. The sensor substrate of any one of the preceding clauses, wherein the charged particle optical component comprises a signal detector configured, when in operation, to detect signal particles emitted from the sample.
Clause 22. The sensor substrate of clause 15, wherein the signal detector comprises a charge type detector element and/or a semiconductor type detector element and/or a scintillating type detector element.
Clause 23. The sensor substrate of either one of clauses 21 or 22, further comprising circuitry configured to process a detection signal generated by the signal detector, desirably the circuitry is comprised in the circuitry layer and/or the insulating layer.
Clause 24. The sensor substrate of any one of the preceding clauses, further comprising circuitry configured to process the measurement signal from the distance sensor.
Clause 25. The sensor substrate of any one of the preceding clauses, wherein at least one aperture is defined through the sensor substrate for the passage of the at least one beam towards the sample.
Clause 26. The sensor substrate of clause 25, wherein the sensor substrate defines an array of apertures for the path of at least one beam towards the sample position.
Clause 27. The sensor substrate of clause 26, wherein the sensor substrate comprises an array of corresponding charged particle optical components, desirably wherein at least one charged particle optical component is associated with at least one of the apertures, desirably wherein at least one charged particle optical component is positioned surrounding at least one of the apertures.
Clause 28. The sensor substrate of any one of the preceding clauses, wherein the sensor substrate comprises an array of charged particle optical components, desirably the charged particle optical components are arranged in a two dimensional array.
Clause 29. The sensor substrate of any of the preceding clauses, wherein the charged particle optical component comprises a lens electrode configured to converge or diverge at least one charged particle beam.
Clause 30. The sensor substrate of any of the preceding clauses, wherein the charged particle optical component comprises a deflector electrode configured to deflect at least one charged particle beam, desirably a plurality of deflector electrodes for each at least one charged particle beam, desirably the plurality of electrodes arranged around each at least one aperture defined in the sensor substrate, desirably wherein the electrodes of the different apertures are controllable separately, desirably the plurality of electrodes for each at least one aperture may be individually controllable .
Clause 31. A charged particle device for projecting a multi-beam of charged particles towards a sample position, the charged particle device comprising the sensor substrate of any of the preceding clauses.
Clause 32. The charged particle device of clause 31, further comprising a plurality of charged particle components up beam of the sensor substrate that are positioned along paths of a plurality of charged particle beams of the multibeam towards a sample position, the plurality of charged particle components configured to operate on the plurality of beams of the multi-beam.
Clause 33. A charged particle assessment apparatus for assessing a sample, desirably configured to project a beam of charged particles towards the sample, the charged particle assessment apparatus comprising the sensor substrate of any one of the preceding clauses, desirably comprising a source configured to emit a charged particle beam, and desirably comprising the charged particle device of clause 31 or 32 wherein the charged particle device comprises the sensor substrate.
Clause 34. A charged particle assessment apparatus for assessing a sample, the charged particle assessment apparatus comprising a sensor substrate of any of clauses 1 to 30.
Clause 35. The charged particle assessment apparatus of clause 33 or 34, further comprising a sample support configured to support the sample, desirably wherein the facing surface of the target is a surface of the sample and/or sample support.
Clause 36. The charged particle assessment apparatus of clause 35, further comprising a sample controller configured to control the position of the sample and/or the sample holder based on the measurement signal from the distance sensor.
Clause 37. The charged particle assessment apparatus of any one of clauses 33 to 36, further comprising a sensor controller configured to control the position of the sensor substrate based on the measurement signal from the distance sensor.
Clause 38. The charged particle assessment apparatus of any one of clauses 33 to 37, wherein the sensor substrate is positioned a) proximate to the sample and/or sample support, and/or b) facing the sample and/or sample support.
Clause 39. A method of generating a measurement signal representative of a distance between a distance sensor to a facing surface of a target using a sensor substrate comprising at least one distance sensor and at least one charged particle optical component, the method comprising: a) positioning the sensor substrate so that the distance sensor faces a facing surface of the target; and b) generating, using the distance sensor, a measurement signal representative of the distance between the distance sensor and the facing surface of a target.
Clause 40. A method of generating a measurement signal representative of a distance between a distance sensor to a facing surface of a target using a sensor substrate comprising a plurality of distance sensors, the method comprising: a) positioning the sensor substrate so that the distance sensor faces a facing surface of the target; and b) generating, using the distance sensor, a measurement signal representative of the distance between the distance sensor and the facing surface of a target.
Clause 41. The method of either one of clauses 39 or 40, further comprising positioning the sample and/or a sample holder and/or the sensor substrate based on the measurement signal from the distance sensor, the positioning desirably comprising using a controller to control the positioning.
Clause 42. The method of clause 41, wherein the positioning comprising scanning the position of the sample and/or the sample holder and/or the sensor substrate relative to a primary charged particle beam directed at the at sample
Clause 43. The method of an one of clauses 39 to 42, further comprising detecting signal particles.
Clause 44. The method of clause 43, wherein the at least one charged particle optical component is at least one signal detector, the detecting signal particles comprising using the at least one signal detector.
Clause 45. A method of projecting a beam of charged particles onto a sample so as to detect signal particles emitted from the sample using a sensor substrate comprising at least one distance sensor and at least one signal detector, the method comprising: a) positioning the sensor substrate so that the distance sensor faces a facing surface of the sample; b) generating, using the distance sensor, a measurement signal representative of the distance between the distance sensor and the facing surface of the sample; c) controlling the position of the sensor substrate and/or the sample and/or a sample holder based on the measurement signal; d) projecting a charged particle beam along a primary beam path onto a surface of the sample; and e) detecting signal particles emitted from the sample at the at least one signal detector.
Clause 46. The method of clause 45, wherein the beam is a multi-beam on impact with the sample, the multi-beam comprising a plurality of sub-beams, desirably the detecting of signal particles comprising detecting signal particles derived from a different sub-beams impacting the sample using a plurality of signal detectors.

## Claims

1. A sensor substrate for a charged particle optical device and/or a charged particle assessment apparatus, the sensor substrate comprising:
at least one distance sensor configured to generate a measurement signal representative of a distance between the distance sensor and a facing surface of a target; and
at least one charged particle optical component.

2. The sensor substrate of claim 1, comprising a plurality of distance sensors.

3. The sensor substrate of claim 2, wherein the plurality of distance sensors are positioned surrounding the at least one charged particle optical component.

4. The sensor substrate of claim 3, wherein the plurality of distance sensors are positioned equidistantly from an origin and/or adjacent distance sensors being separated by similar distances.

5. The sensor substrate of any of the preceding claims, wherein the distance sensor is proximate to the at least one charged particle optical component.

6. The sensor substrate of any of the preceding claims, wherein a sensing surface of the distance sensor and a main surface of the charged particle optical component are configured, when in operation, to face a target..

7. The sensor substrate of claim 6, wherein the sensing surface of the distance sensor and the main surface of the charged particle optical component are parallel to each other.

8. The sensor substrate of either of claims 6 or 7, wherein the sensing surface of the distance sensor and the main surface of the charged particle optical component are in the same plane.

9. The sensor substrate of any of the preceding claims, wherein the distance sensor comprises at least part of an isolating element, desirably the or each distance sensor comprising a sensing electrode, desirably the sensing electrode configured to be supported by the isolating element.

10. The sensor substrate of claim 9, wherein at least part of a circuitry of the sensor substrate is positioned in the isolating element,

11. The sensor substrate of claim 10, wherein the circuitry in a portion of the isolating layer associated with the at least one distance sensor is the circuitry of the at least one distance sensor, desirably each portion corresponding in shape to a shape of the distance sensor.

12. The sensor substrate of any of the preceding claims, wherein the distance sensor is a capacitive sensor.

13. The sensor substrate of any of the preceding claims, wherein the charged particle optical component comprises a signal detector configured, when in operation, to detect signal particles emitted from the sample.

14. The sensor substrate of any one of the preceding claims, wherein the charged particle optical component comprises at least part of an isolating element, desirably the or each charged particle element comprising one or more detector electrodes, desirably the or each detector electrode is configured to face, when in operation, the target.

15. The sensor substrate of any of the preceding claims, wherein at least one aperture is defined through the sensor substrate for the passage of the at least one beam towards the sample.
